# FASCICULE DE BREVET EUROPEEN

(11) **EP 3 107 118 B1**
(45) Date de publication et mention de la délivrance du brevet: **12.02.2020**
(21) Numéro de dépôt: 16174871.0
(22) Date de dépôt: 16.06.2016
(51) Int. Cl.: H01L 21/8234, H01L 21/8238, H01L 29/66

(54) **PROCÉDÉ DE FORMATION DES ESPACEURS D'UNE GRILLE D'UN TRANSISTOR**
VERFAHREN ZUR BILDUNG VON ABSTANDHALTERN EINES GATES EINES TRANSISTORS
METHOD FOR FORMING SPACES OF A TRANSISTOR GATE

(30) Priorité: 19.06.2015 FR 1555663
(43) Date de publication de la demande: 21.12.2016
(73) Titulaire: COMMISSARIAT À L'ÉNERGIE ATOMIQUE ET AUX ÉNERGIES ALTERNATIVES, 75015 Paris (FR)
(72) Inventeur: POSSEME, Nicolas, 38360 SASSENAGE (FR)
(74) Mandataire: Hautier, Nicolas

(56) Documents cités:
- EP-A1- 2 750 170
- US-A1- 2008 242 092
- US-A1- 2013 252 430
- US-A1- 2014 369 115
- US-A1- 2015 162 416

## Description

### DOMAINE TECHNIQUE DE L'INVENTION

La présente invention concerne en général les transistors à effet de champs (FET) utilisés par l'industrie de la microélectronique et plus particulièrement la réalisation des espaceurs de grille des transistors de type métal-oxyde-semi-conducteur (MOSFET) majoritairement utilisés pour la production de toutes sortes de circuits intégrés.

### ÉTAT DE LA TECHNIQUE

La course incessante à la réduction des dimensions qui caractérise toute l'industrie de la microélectronique n'a pu se faire qu'avec l'apport d'innovations clés tout au long de décennies de développement depuis que les premiers circuits intégrés ont été produits industriellement dans les années soixante. Une innovation très importante qui remonte aux années soixante-dix, et qui est toujours utilisée, consiste à réaliser les transistors MOSFET à l'aide d'une technique dans laquelle les électrodes de source et de drain sont auto alignés sur celles de grille et ne nécessitent donc pas d'opération de photogravure pour leur définition. Combiné avec l'utilisation de grilles en silicium polycristallin, ce sont les grilles elles-mêmes, réalisées en premier, qui servent de masque lors du dopage des zones de source et drain des transistors.

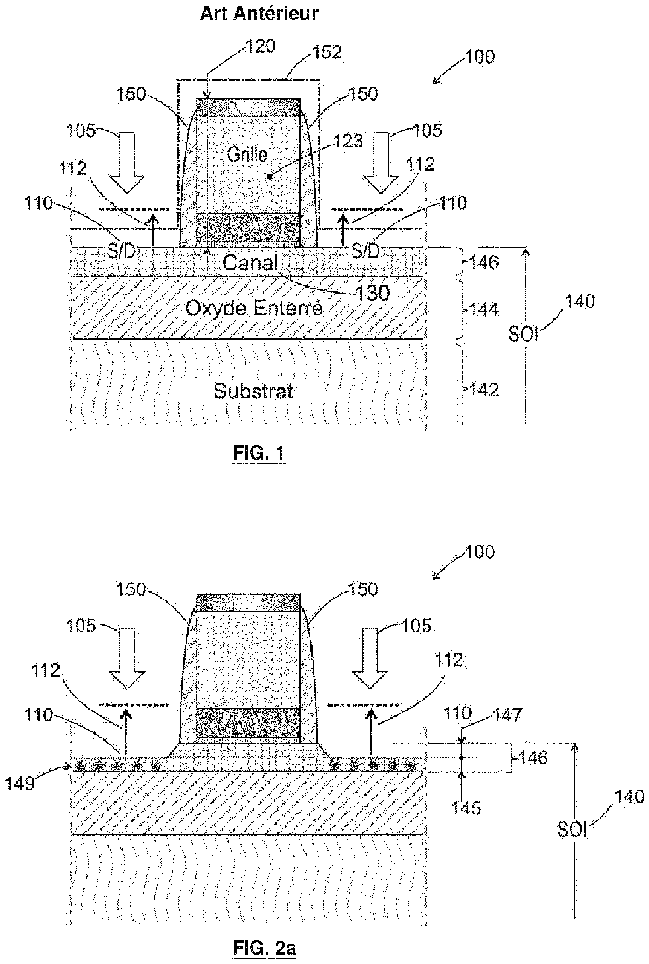

La **figure 1** est une vue en coupe d'un exemple de ce type de transistor 100 en cours de réalisation. On y retrouve les zones de source et de drain 110, globalement désignées zones source/drain, puisqu'elles sont très généralement parfaitement symétriques et peuvent jouer les deux rôles en fonction des polarisations électriques qui sont appliquées au transistor. La grille est classiquement constituée d'un empilement de couches 120 dont une grande partie est toujours constituée de silicium polycristallin 123. La formation des zones de source et drain se fait typiquement par implantation ionique 105 de dopants dans les zones 110, la grille 120 servant de masque comme mentionné ci-dessus, empêchant ainsi le dopage de la zone du transistor MOSFET dans laquelle, en fonction des tensions appliquées sur la grille, va pouvoir se développer le canal 130 de conduction entre source et drain.

La technique de base, très brièvement décrite ci-dessus, bien connue de l'homme du métier ainsi que de nombreuses variantes, a été constamment perfectionnée dans le but d'améliorer les performances électriques des transistors tout en permettant d'accommoder les réductions de taille successives des transistors nécessitées par une intégration toujours croissante d'un plus grand nombre de composants dans un circuit intégré.

Une technique largement utilisée actuellement consiste à fabriquer les circuits intégrés en partant de substrats élaborés 140 de type silicium sur isolant, désignés par leur acronyme SOI, de l'anglais « silicon on insulator ». Le substrat élaboré SOI est caractérisé par la présence d'une fine couche superficielle de silicium monocristallin 146 reposant sur une couche continue d'oxyde de silicium 144, dit oxyde enterré ou encore BOX, acronyme de l'anglais « buried oxide layer ». La solidité et la rigidité mécanique de l'ensemble sont assurées par la couche 142 qui constitue le corps du substrat SOI, souvent qualifié du vocable anglais de « bulk » pour indiquer que le substrat de départ est très généralement fait de silicium massif. Cette structure offre de nombreux avantages pour la réalisation des transistors MOSFET. Notamment, elle permet une réduction drastique des capacités parasites en raison de la présence de la couche continue isolante 144. En ce qui concerne l'invention, on retiendra seulement que la couche superficielle de silicium monocristallin 146 peut être contrôlée précisément en épaisseur et en dopage. En particulier, il est avantageux pour les performances des transistors que le canal 130 puisse être complètement déserté de porteurs, c'est-à-dire « fully depleted » (FD), vocable anglais qui est généralement utilisé pour désigner cet état. Ceci est obtenu en réalisant les transistors à partir de substrats SOI dont la couche superficielle 146 est très mince ce qui n'est pas sans inconvénient par ailleurs comme on le verra dans la description de l'invention. Ce type de transistor est ainsi désigné par l'acronyme FDSOI.

Un perfectionnement de la technique de base d'auto alignement qui a été universellement adopté consiste en la formation d'espaceurs 150 sur les flancs de la grille. Les espaceurs 150, typiquement faits de nitrure de silicium (SiN), vont permettre en particulier la mise en oeuvre d'une technique dite de « Source et Drain surélevés ». Pour pouvoir maintenir de faibles résistances électriques d'accès aux électrodes de source et de drain, en dépit de la réduction de taille des transistors, il a fallu en effet augmenter leur section. Ceci est obtenu par épitaxie sélective des zones source/drain 110. Au cours de cette opération on va faire croître 112 localement la couche initiale de silicium monocristallin 146. Il faut alors protéger les zones de grilles pour empêcher la croissance de se faire également à partir du silicium polycristallin 123 de la grille. C'est, entre autres, le rôle des espaceurs que d'assurer cette fonction. Ils assurent également un rôle de préservation de la grille lors de la siliciuration des contacts (non représentée) qui est ensuite effectuée dans le même but afin de diminuer la résistance série d'accès aux électrodes du transistor.

La formation des espaceurs 150 est devenue une étape cruciale de formation des transistors qui atteignent désormais des dimensions qui se mesurent couramment en nanomètres (nm = 10⁻⁹ mètres) et qui sont globalement de tailles décananométriques. La réalisation des espaceurs se fait sans faire intervenir aucune opération de photogravure. Ils sont auto alignés sur la grille 120 à partir du dépôt d'une couche uniforme de nitrure de silicium 152 (SiN) qui subit ensuite une gravure très fortement anisotrope. Cette gravure du SiN attaque préférentiellement les surfaces horizontales, c'est-à-dire toutes les surfaces qui sont parallèles au plan du substrat SOI. Elle ne laisse en place, imparfaitement, que les parties verticales de la couche 152, celles sensiblement perpendiculaires au plan du substrat, afin d'obtenir en pratique les motifs 150 dont la forme idéale serait évidemment rectangulaire.

Avec les solutions connues, la réduction de taille des transistors rend très délicate l'obtention d'espaceurs jouant pleinement leur rôle d'isolation et n'induisant pas de défauts dans la réalisation de transistors à partir de substrats SOI. En effet, dans le cadre de la présente invention, et comme cela sera détaillé par la suite, il a été constaté que plusieurs types de défaut tels que ceux mentionnés ci-dessous apparaissent lors de la gravure des espaceurs en utilisant l'un ou l'autre des procédés connus de gravure anisotrope.

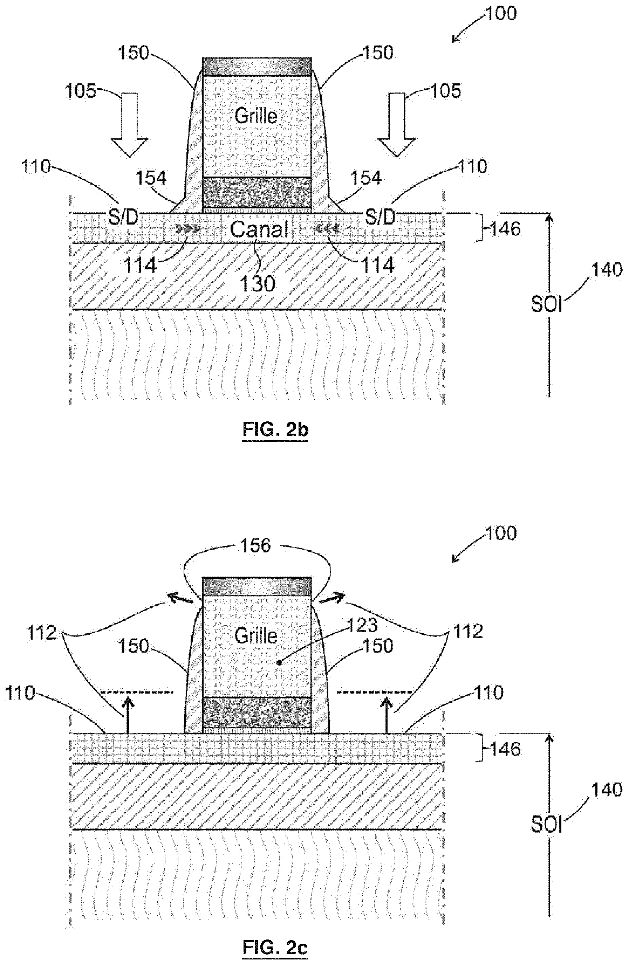

Les **figures 2a****,** **2b et 2c** illustrent chacune un type de défaut observé.

On utilise notamment un type de gravure qui est dite « sèche » et qui se met en oeuvre à l'aide d'un procédé qui est le plus souvent désigné par son acronyme RIE, de l'anglais « reactive-ion eching », c'est-à-dire : « gravure ionique réactive ». Il s'agit d'un procédé de gravure dans lequel on forme, dans une enceinte confinée, un plasma qui réagit physiquement et chimiquement avec la surface de la tranche à graver. Dans le cas de la gravure d'une couche de nitrure de silicium, qui est comme on l'a vu le matériau préféré pour la réalisation des espaceurs, le gaz réactif est typiquement le fluorure de méthyle (CH3F) que l'on fait réagir avec le matériau à graver en introduisant également du dioxygène (O2). On forme ainsi un plasma de gravure basé sur la chimie du fluor et souvent désigné par ses constituants : CH3F/O2/He.

Dans le plasma basé sur la chimie CH3F/O2/He, le composé fluor sert à graver le nitrure de silicium tandis que l'oxygène permet de limiter la polymérisation du fluorure de méthyle et sert également à oxyder le silicium lorsque ce matériau est atteint en cours de gravure. La couche d'oxyde formée sur le silicium permet de ralentir la gravure du silicium au prix cependant d'une transformation en surface de ce dernier en oxyde et donc d'une consommation superficielle de silicium. L'hélium sert de diluant pour l'oxygène et le CH3F.

L'avantage de ce type de gravure est qu'elle est assez anisotrope et permet de contrôler suffisamment le profil des espaceurs 150 même si l'on ne peut pas obtenir en pratique la forme rectangulaire idéale. L'inconvénient de ce type de gravure est que la sélectivité d'attaque du silicium sous-jacent est cependant limitée. La sélectivité, c'est-à-dire le rapport des vitesses de gravure entre le nitrure de silicium et le silicium est de l'ordre de 10 et peut atteindre 15 au maximum en fonction des conditions de formation du plasma (le nitrure est gravé 10 à 15 fois plus vite que le silicium).

On utilise aussi des gravures dites « humides » à base d'acide fluorhydrique (HF) ou d'acide phosphorique (H3PO4) qui ont une bien meilleure sélectivité, respectivement, vis-à-vis du silicium ou de son oxyde (SiO2) mais qui ne permettent pas cependant de contrôler le profil des espaceurs puisque la gravure est essentiellement isotrope dans ce cas. On notera ici que ce type de gravure est aussi qualifié de « nettoyage humide » traduction de l'anglais « wet clean ».

On notera ici qu'il existe de nombreuses publications sur le sujet de la gravure du nitrure de silicium et/ou des espaceurs de grille en général. On pourra se référer par exemple aux brevets ou demandes de brevets américains suivants : 2003/0207585 ; 4 529 476 ; 5 786 276 et 7 288 482, et à la demande de brevet européen EP 2750 170 A1.

La **figure 2a** illustre un premier problème qui est en relation avec la sélectivité insuffisante d'attaque qui existe lors d'une gravure sèche de type CH3F/O2/He entre le nitrure de silicium et le silicium de la couche superficielle 146. Le résultat est qu'une fraction significative de la mince couche superficielle de silicium monocristallin 146 du substrat SOI peut être alors partiellement consommée 147 lors de la gravure anisotrope du nitrure. Comme précédemment mentionné, la couche superficielle 146 est choisie pour être de faible épaisseur afin d'améliorer les caractéristiques électriques des transistors. Elle est typiquement inférieure à 10 nm. L'épaisseur restante 145 peut être très faible. Dans ces conditions l'implantation ionique 105 pour former les zones de source et de drain 110 qui va suivre est susceptible d'être très dommageable pour le silicium monocristallin restant. L'énergie d'implantation des dopants peut être suffisante pour provoquer une amorphisation complète 149 du silicium monocristallin ce qui va alors notamment compromettre l'étape de croissance épitaxiale 112 suivante destinée à former les source/drain surélevés. Comme précédemment mentionné, cette dernière opération est rendue nécessaire en raison de la diminution de taille des transistors afin de pouvoir maintenir les résistances d'accès aux électrodes de source et de drain à des valeurs suffisamment faibles pour ne pas impacter le fonctionnement électrique des transistors. Une croissance à partir d'une couche de silicium partiellement ou totalement rendue amorphe va créer de nombreux défauts dans la couche formée par épitaxie.

La **figure 2b** illustre un autre problème où il n'y a pas consommation significative du silicium de la couche superficielle 146 mais il y a formation de « pieds » 154 au bas des motifs de nitrure de silicium restants sur les flancs de la grille après gravure. La conséquence est que la transition 114 des jonctions qui sont formées après dopage par implantation ionique 105 des zones de source et drain 110, avec la zone du canal 130, est beaucoup moins abrupte que lorsque les espaceurs n'ont pas de pieds comme représenté dans les figures précédentes. La présence de pieds 154 affecte les caractéristiques électriques des transistors. On remarquera ici que la formation ou non de pieds au bas des espaceurs et la consommation ou non de silicium de la couche superficiel de silicium 146 du substrat SOI, décrite dans la figure précédente, sont des paramètres de réglage antagonistes de la gravure qui nécessitent qu'un compromis puisse être trouvé pour lequel, idéalement, on ne forme pas de pieds et on n'attaque pas significativement la couche superficielle de silicium.

La **figure 2c** illustre un troisième problème qui se produit quand la gravure produit une érosion trop importante des espaceurs dans les parties hautes des grilles et met à nu le silicium polycristallin 123 dans ces zones 156. La conséquence est que la croissance épitaxiale 112 ultérieure pour former les source/drain surélevés va aussi se produire à ces endroits, ainsi qu'une siliciuration de contacts parasites, ce qui risque de provoquer des courts circuits entre électrodes. En effet, la gravure des espaceurs demande que le temps de gravure soit ajusté pour graver, par exemple, 150% de l'épaisseur de nitrure déposé. C'est-à-dire que l'on pratique une surgravure de 50% dans cet exemple afin de tenir compte de la non uniformité du dépôt, ou de l'opération de gravure elle-même, au niveau d'une tranche. Ainsi, dans certaines parties de la tranche on pourra constater qu'il y a une surgravure trop prononcée qui met à nu les zones de grille 156. Ce type de défaut est aussi qualifié de « facettage ».

On voit donc que la gravure plasma, si elle a permis de suivre les réductions de taille des motifs à chaque introduction d'un nouveau nœud technologique dans les années passées, pose cependant de plus en plus de problèmes quand la taille diminue, en particulier au-delà du nœud technologique de 22 nm. La mise en œuvre de la gravure plasma pour ces dimensions introduit un degré de complexité supplémentaire pour essayer de pallier les problèmes décrits ci-dessus. Des chimies de gravure plus complexes que celle traditionnelle, dite fluorocarbonée, ont été testées qui nécessitent d'introduire des gaz supplémentaires dans la chambre de gravure (voir le document US 2013/0252430-A1). Jusqu'à cinq gaz différents ont été combinés pour former le plasma de gravure. Cela a pour conséquence première de complexifier considérablement le procédé.

La présente invention a pour objet de proposer un procédé de formation d'espaceurs jouant pleinement leur rôle d'isolation et qui supprimerait ou limiterait au moins certains des défauts dans la réalisation de transistors, tels que la consommation ou l'altération du matériau semi-conducteur (i.e. Si, SiGe) de la couche active, la formation de « pieds » au bas des motifs sur les flancs de la grille d'un transistor.

Un autre objectif particulier de la présente invention est de se passer d'une chimie fluorocarbonée.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Pour atteindre cet objectif, un aspect de la présente invention concerne un procédé de formation des espaceurs d'une grille d'un transistor à effet de champ, la grille comprenant un sommet et des flancs et étant située au-dessus d'une couche active en un matériau semi-conducteur, comprenant : une étape de formation d'une couche de protection recouvrant ladite; au moins une étape de formation d'un film carboné sur le transistor ; au moins une étape de retrait de portions du film carboné, réalisée en mettant en présence du film carboné avec un plasma créant un bombardement d'ions de sorte à enlever au moins des portions du film carboné situées sur le sommet et de part et d'autre de la grille et qui sont perpendiculaires à la direction principale en laissant en place des portions résiduelles du film carboné au niveau des flancs de la grille ; au moins une étape de modification de la couche de protection réalisée en mettant en présence de la couche de protection avec un plasma comprenant des ions à base d'hydrogène (H, H⁺, H₂⁺, H₃⁺ etc.) et/ou à base d'hélium (He) et créant un bombardement anisotrope d'ions de sorte à modifier au moins des portions de la couche de protection qui sont situées sur le sommet et de part et d'autre de la grille, en conservant des portions non-modifiées de la couche de protection recouvrant les flancs de la grille et au moins une étape de retrait de la couche de protection modifiée à l'aide d'une gravure sélective de la couche de protection modifiée vis-à-vis des portions non-modifiées de la couche de protection et vis-à-vis des portions résiduelles du film carboné.

Ainsi l'étape de formation du film carboné et l'au moins une étape de modification de la couche de protection sont réalisées l'une après l'autre c'est-à-dire qu'elles ne sont pas réalisées simultanément.

Ainsi lors de l'étape de modification de la couche de protection on évite les risques de voir du carbone pénétrer dans la couche active. Cette dernière n'est donc pas altérée. Dans le cadre de la présente invention, il a été remarqué que si l'étape de formation du film carboné et l'étape de modification de la couche de protection sont effectuées simultanément, alors une partie du carbone présent dans le plasma destiné à former le film carboné pénètre dans la couche active et altère cette dernière. Les performances du transistor sont alors amoindries.

L'invention permet ainsi d'obtenir des espaceurs de grille aux dimensions particulièrement précises, tout en supprimant voire en limitant les risques de consommation du matériau semi-conducteur et la formation de « pieds » au bas de la grille. On évite par ailleurs, l'altération du matériau semi-conducteur de la couche active ce qui conduit à des défauts durant les étapes ultérieures de croissance épitaxiale à partir de la couche active.

De préférence, l'étape de retrait de la couche de protection modifiée permet de graver la couche de protection modifiée de manière sélective par rapport aux portions non-modifiées de la couche de protection et par rapport aux portions résiduelles du film carboné.

Ainsi le film carboné présent sur les flancs de la grille protège, lors de l'étape de retrait de la couche de protection modifiée, les portions non-modifiées de la couche de protection présentes entre le film carboné et la grille.

En effet il s'avère qu'en pratique la sélectivité entre la couche de protection modifiée et les portions non-modifiées n'est pas infinie. Il en résulte que sans les portions résiduelles du film carboné une consommation latérale des espaceurs est constatée lors du retrait de la couche de protection modifiée. Cette consommation latérale, même légère, induit une baisse des performances du transistor.

L'invention, en prévoyant un film carboné protecteur qui demeure lors du retrait de la couche de protection modifiée permet ainsi de préserver efficacement l'épaisseur des espaceurs et améliore ainsi les performances du transistor.

Par ailleurs, dans les modes de réalisation où le film carboné recouvre la couche de protection située sur les flancs de la grille lors de l'étape de modification de la couche de protection, ce film carboné évite que la couche de protection située sur les flancs de la grille ne soit modifiée par une déplétion d'ions qui n'auraient pas une direction parfaitement parallèle aux flancs de la grille. On évite ainsi une modification involontaire de la couche de protection située sur les flancs de la grille lors de l'étape de modification.

Par ailleurs, les modes de réalisation dans lesquels l'étape de modification de la couche de protection est effectuée avant de recouvrir les flancs de la grille par le film carboné, présentent pour avantage de permettre une implantation au plus près de la grille. L'épaisseur modifiée de la couche de protection est donc maîtrisée avec plus de précision. Au final ce mode de réalisation permet de répondre avec une très grande efficacité à la problématique consistant à améliorer la précision de la formation des espaceurs de la grille.

Un film carboné est un film comprenant des espèces chimiques contenant du carbone. Selon un mode de réalisation non limitatif le film carboné est en carbone.

Par ailleurs, l'invention présente comme avantage de se passer des chimies fluorocarbonée, dont certaines des inconvénients ont été rappelés ci-dessus.

Sont énoncées ci-après des caractéristiques optionnelles qui peuvent éventuellement être utilisées en association ou alternativement avec les caractéristiques ci-dessus:
Préférentiellement, le plasma utilisé lors de l'étape de retrait de portions du film carboné comprend des ions plus lourds que l'hydrogène (H2), ledit bombardement des ions plus lourds que l'hydrogène étant réalisé de manière anisotrope selon une direction principale qui est parallèle à des flancs de la grille, de sorte à enlever au moins les portions du film carboné situées sur le sommet et de part et d'autre de la grille, en laissant en place les portions résiduelles du film carboné au niveau des flancs de la grille.

De manière avantageuse mais non limitative, le plasma utilisé lors de l'étape de retrait de portions du film carboné comprend des ions pris parmi l'argon (Ar), l'hélium (He), l'azote (N2) et l'oxygène (O2).

Le bombardement d'ions plus lourds que l'hydrogène détruit le film carboné formé sur les surfaces perpendiculaires à ladite direction principale d'implantation.

La direction principale est également désignée direction du bombardement ou direction privilégiée du bombardement.

De manière préférentielle, l'étape de modification de la couche de protection est réalisée de manière à ce que le plasma provoque un bombardement anisotrope d'ions à base d'hydrogène ou/et d'hélium selon une direction privilégiée qui correspond à ladite direction principale et qui est parallèle aux flancs de la grille.

Les ions à base d'hydrogène sont de préférence pris parmi : H, H⁺, H₂⁺, H₃⁺.

De préférence, l'étape de modification de la couche de protection est effectuée de manière les ions du plasma (c'est-à-dire les ions à base d'hydrogène (H, H⁺, H₂⁺, H₃⁺ etc.) et/ou à base d'hélium (He)), s'implantent dans les portions de la couche de protection à graver ultérieurement.

Avantageusement, l'étape de retrait de portions du film carboné est réalisée de manière à enlever l'intégralité du film carboné situé sur le sommet et de part et d'autre de la grille.

Avantageusement, l'étape de retrait de portions du film carboné est réalisée de manière à conserver l'intégralité du film carboné situé au niveau des flancs de la grille.

De manière avantageuse mais non limitative, l'étape de retrait de portions du film carboné et l'étape de modification de la couche de protection sont réalisées simultanément, de préférence en utilisant un même plasma comprenant des ions à base d'hydrogène (H, H⁺, H₂⁺, H₃⁺ etc.) ou/et d'hélium (He). De manière préférentielle, ledit plasma comprend en outre des ions plus lourds que l'hydrogène pris parmi l'argon (Ar), l'hélium (He), l'azote (N2) et/ou l'oxygène (O2).

Autrement dit, l'étape de modification est réalisée de manière à enlever le film carboné notamment sur des surfaces perpendiculaires à la direction principale d'implantation.

Lesdites portions non-modifiées de la couche de protection peuvent ainsi constituer les espaceurs de protection pour la grille.

Dans un mode de réalisation où la couche de protection est à base de de nitrure, le bombardement d'ions hydrogène (H) et/ou l'hélium (He) lors de l'étape de modification conduit à implanter ces ions dans les couches visées. Cette modification par implantation d'ions permet d'améliorer considérablement la sélectivité de cette couche par rapport au matériau semi-conducteur, typiquement du silicium. Cette implantation fait également que l'épaisseur de la couche de protection modifiée se grave plus rapidement que les portions non-modifiées de la protection.

La gravure consomme ainsi la couche de protection modifiée préférentiellement à la couche de matériau semi-conducteur et aux portions non-modifiées de la couche de protection. Ainsi, le risque de consommation excessive de la couche superficielle de matériau semi-conducteur est réduit voir supprimé.

De préférence, la modification de la couche de protection conserve une épaisseur non modifiée sur les flancs de la grille. Cette épaisseur est conservée, au moins en partie, lors de la gravure sélective. Elle définit alors des espaceurs de protection de grille.

L'invention permet ainsi d'obtenir des espaceurs de protection tout en réduisant voire en éliminant les problèmes des solutions connues et mentionnés précédemment.

L'implantation réalisée à partir d'un plasma comprenant lesdits ions à base d'hydrogène (H, H⁺, H₂⁺, H₃⁺ etc.) et/ou d'hélium (He) a pour avantage de permettre une implantation de manière continue dans un volume s'étendant dès la surface de la couche implantée.

En outre l'utilisation d'un plasma permet une implantation à des profondeurs plus faibles que les profondeurs minimales que l'on peut obtenir avec des implanteurs. Ainsi, une implantation par plasma permet d'implanter efficacement et de manière relativement homogène ou tout au moins de manière continue des épaisseurs fines que l'on peut ensuite retirer par une gravure sélective. Cette continuité d'implantation depuis la face implantée permet d'améliorer l'homogénéité de la modification selon la profondeur, ce qui conduit à une vitesse de gravure constante dans le temps de la couche implantée. Par ailleurs, l'augmentation de la sélectivité conférée par l'implantation vis à vis des autres couches est effective dès le début de la gravure de la couche implantée. L'implantation par plasma permet ainsi un contrôle significativement amélioré de la précision de gravure.

L'implantation plasma d'espèce à base d'hydrogène permet typiquement d'implanter puis de retirer des épaisseurs s'étendant depuis la surface de la couche implantée et sur une profondeur allant de 0 nm à 100 nm. Les implanteurs classiques, permettent une implantation dans un volume compris entre 30 nm et plusieurs centaines de nanomètres. En revanche, les implanteurs classiques ne permettent pas d'implanter les espèces H entre la surface de la couche à implanter et une profondeur de 30 nm. Dans le cadre du développement de la présente invention, il a été remarqué que les implanteurs ne permettent alors pas d'obtenir une vitesse de gravure suffisamment constante de la couche de protection modifiée et ce depuis la surface de cette dernière, conduisant ainsi à une moindre précision de gravure comparé à ce que permet l'invention.

L'utilisation d'un plasma pour modifier la couche à retirer est donc particulièrement avantageuse dans le cadre de l'invention qui vise à retirer une fine épaisseur de nitrure, typiquement comprise entre 1 et 10 nm et plus généralement entre 1 et 30 nm.

L'étape de modification réalisée à partir d'un plasma modifie la couche à de protection de manière continue depuis la surface de la couche de protection et sur une épaisseur comprise entre 1 nm et 30 nm et de préférence entre 1 nm et 10 nm.

Ainsi, lors des étapes de retrait du film de carboné et de modification de la couche de protection réalisées préférentiellement de manière simultanée, les conditions du plasma, l'énergie des ions et la direction principale d'implantation sont choisies de manière à ce que :
∘ le plasma créé un bombardement d'ions à base d'hydrogène (H, H⁺, H₂⁺, H₃⁺ etc.) ou/et d'hélium (He) de manière anisotrope selon la direction principale qui est parallèle aux flancs de la grille et de sorte à modifier au moins une portion supérieure de l'épaisseur de la couche de protection au niveau des flancs de la grille en conservant des portions non-modifiées de la couche de protection recouvrant les flancs de la grille,
∘ le plasma créé un bombardement des ions plus lourds que l'hydrogène qui retire le film carboné précédemment formé sur des surfaces perpendiculaires à la direction principale.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La FIGURE 1 illustre une vue en coupe d'un exemple de transistor MOSFET de type FDSOI en cours de réalisation.
Les FIGURES 2a à 2c illustrent différents défauts qui peuvent être observés sur des structures de transistors FDSOI lors de la gravure des espaceurs en utilisant l'un ou l'autre des procédés standard de gravure anisotrope développés par l'industrie de la microélectronique.
La FIGURE 3 résume les principales étapes de plusieurs exemples de procédé de formation d'espaceurs d'un transistor selon l'invention.
Les FIGURES 4a à 4e illustrent les structures obtenues à l'issue des certaines des étapes de procédés selon des modes de réalisation de l'invention.

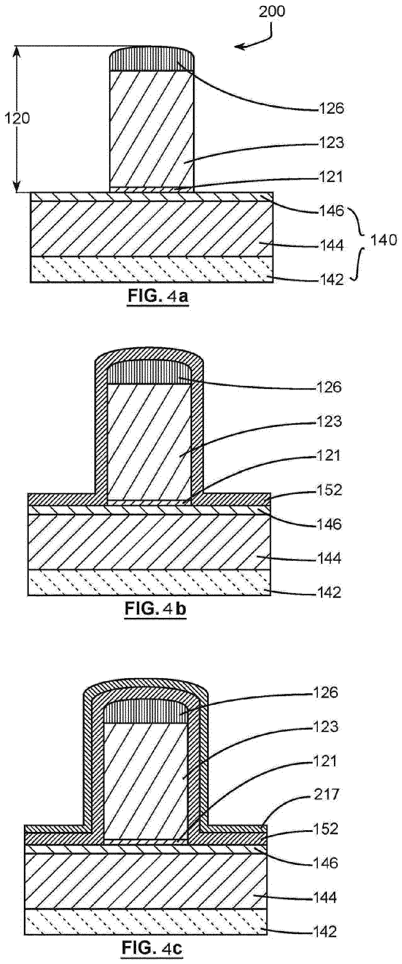

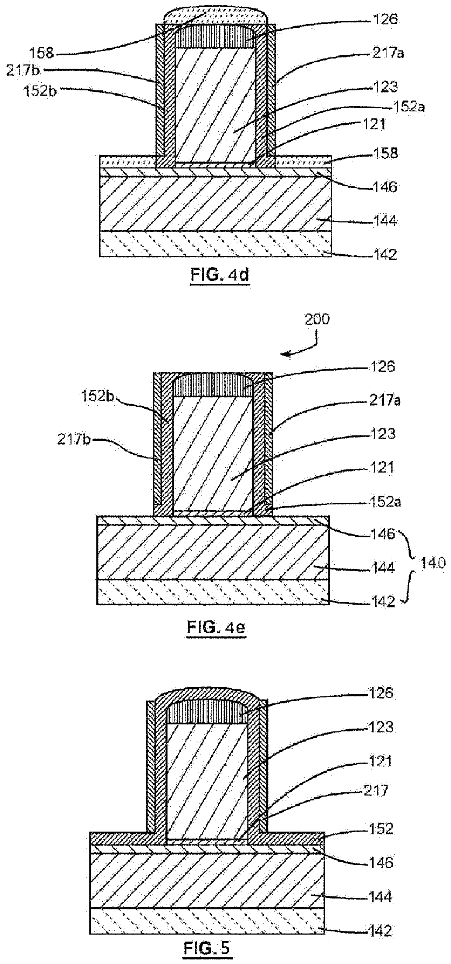

Les FIGURES 4a à 4c, 5, 4d et 4e illustrent respectivement une structure d'un transistor obtenue à l'issue d'une des étapes d'un procédé selon un mode de réalisation alternatif de l'invention.

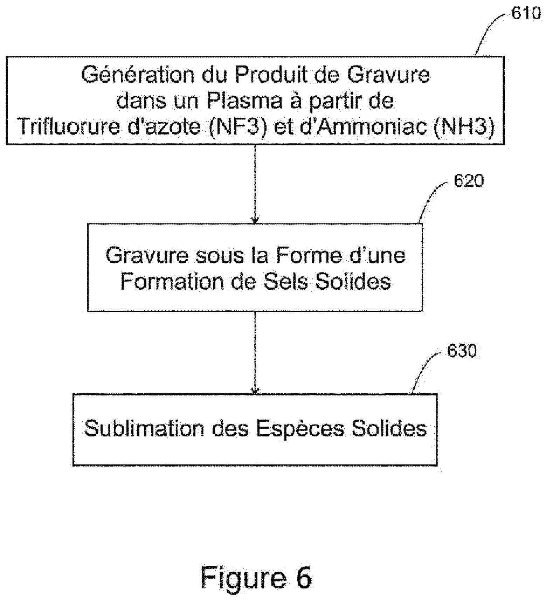

La FIGURE 6 illustre les étapes du retrait par voie sèche de la couche de protection modifiée.

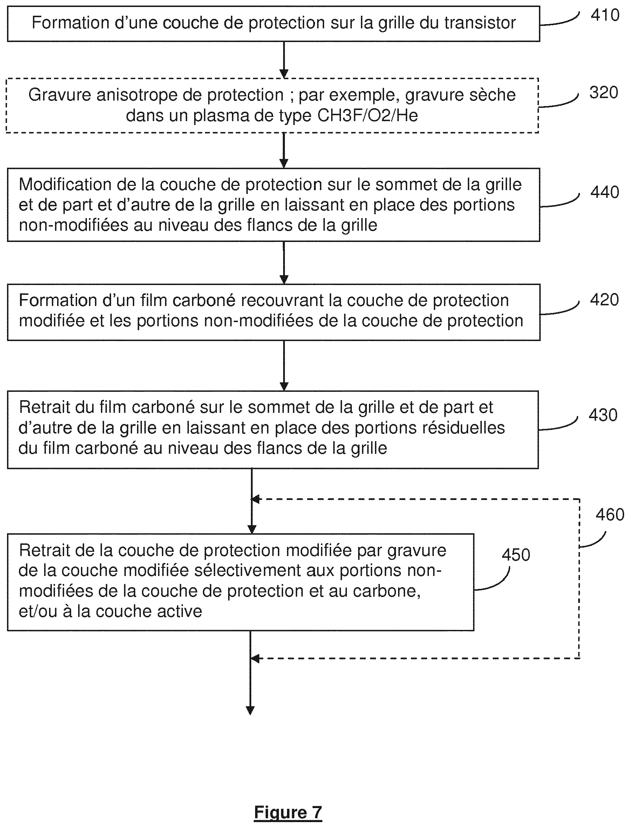

La FIGURE 7 résume les principales étapes d'un exemple alternatif de procédé de formation d'espaceurs d'un transistor selon un l'invention.

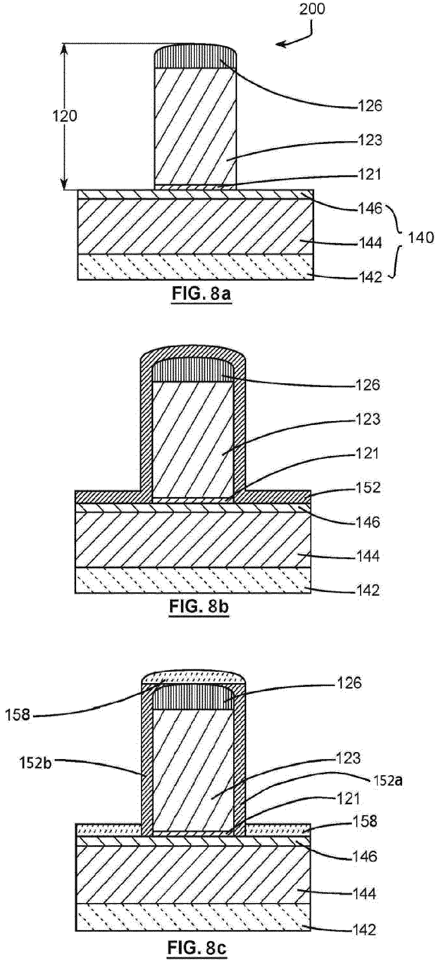

Les FIGURES 8a à 8f illustrent respectivement une structure d'un transistor obtenue à l'issue d'une des étapes d'un procédé selon un autre mode de réalisation alternatif différent des deux modes de réalisation illustrés précédemment.

Les dessins joints sont donnés à titre d'exemples et ne sont pas limitatifs de l'invention. Ces dessins sont des représentations schématiques et ne sont pas nécessairement à l'échelle de l'application pratique. En particulier, les épaisseurs relatives des couches et des substrats ne sont pas représentatives de la réalité.

### DESCRIPTION DÉTAILLÉE DE L'INVENTION

Il est précisé que dans le cadre de la présente invention, le terme « sur », « surmonte », « recouvrir » ou « sous jacent » ou leurs équivalent ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

Dans la description qui suit, les épaisseurs sont généralement mesurées selon des directions perpendiculaires au plan de la face inférieure de la couche à graver ou d'un substrat sur lequel la couche inférieure est disposée. Ainsi, les épaisseurs sont généralement prises selon une direction verticale sur les figures représentées. En revanche l'épaisseur d'une couche recouvrant un flanc d'un motif est prise selon une direction perpendiculaire à ce flanc.

Avant d'entamer une revue détaillée de modes de réalisation de l'invention, sont énoncées ci-après des caractéristiques optionnelles qui peuvent éventuellement être utilisées en association ou alternativement :
Les ions plus lourds que l'hydrogène du plasma, pris parmi l'argon (Ar), l'hélium (He), l'azote (N2), le xénon (Xe) et l'oxygène (O2), peuvent être utilisés alternativement ou être combinés dans un même plasma. Leur rôle est d'empêcher la formation du film carboné dans le fond du motif. D'autres ions peuvent convenir.

La couche de protection est préférentiellement une couche de nitrure de silicium.

L'étape de retrait de la couche de protection modifiée, est de préférence effectuée par gravure humide sélective au carbone, aux portions non-modifiées de la couche de protection, et/ou audit matériau semi-conducteur de la couche active et/ou à l'oxyde de silicium (SiO2). Dans ce cas, la couche de protection modifiée est consommée très facilement par rapport à la consommation du carbone, du matériau semi-conducteur de la couche active (typiquement du silicium) et/ou de l'oxyde de silicium (SiO2).

Dans un mode de réalisation préférentiel où la couche de protection est à base de nitrure, les solutions prévoit en effet une solution de gravure à base d'acide fluorhydrique (HF) qui consomme le nitrure à une vitesse de 0.5 nm/minute et avec une sélectivité du nitrure par rapport au silicium de l'ordre de 20 à 30.

De plus, la sélectivité du nitrure modifié par rapport au carbone et au nitrure non-modifié est respectivement supérieure à 100 et à 30.

Cela permet donc d'améliorer considérablement la sélectivité et donc la précision de la gravure.

On évite ainsi de consommer de manière excessive la couche active, de découvrir les flancs de la grille ou de former des pieds.

D'autres caractéristiques optionnelles de l'invention, qui peuvent être mises en oeuvre de façon combinée selon toutes combinaisons ou de manière alternative, sont indiquées ci-après :
- Préférentiellement, la couche de protection est une couche à base de nitrure ou une couche dont le matériau présente une constante diélectrique égale ou inférieure 8 et de préférence à 7. Selon un mode de réalisation le matériau présente une constante diélectrique égale ou inférieure à celle du nitrure de silicium.
- Dans un mode de réalisation présentiel, la couche de protection est une couche à base de nitrure de silicium. Avantageusement, la couche de protection est une couche de nitrure de silicium.
- Dans un autre mode de réalisation avantageux, le matériau de la couche de protection est pris parmi le nitrure de bore (BN), le SiCBN, le SiOCN, le SiCO, le SiC.
   - Selon un mode de réalisation, les paramètres d'implantation, en particulier l'énergie communiquée aux ions à base d'hydrogène (H, H⁺, H₂⁺, H₃⁺ etc.) et/ou à base d'hélium (He), la durée, la dose d'implantation et la direction principale d'implantation, ainsi que la nature des ions sont prévus de sorte que les portions modifiées de la couche à graver puissent être gravées sélectivement par rapport au film carboné. Ces paramètres sont également réglés de manière à ce que les portions modifiées de la couche à graver puissent être gravées sélectivement par rapport aux portions non modifiées de la couche à graver. Ces paramètres sont également réglés de manière à ce que les portions modifiées de la couche à graver puissent être gravées sélectivement par rapport à la couche sous-jacente à la couche à graver.
- Avantageusement, l'étape de formation du film carboné est réalisée à partir d'un plasma à base de CxHyFz, CxHy or CxFy où x est la proportion de carbone, y et/ou z sont respectivement la proportion d'hydrogène ou/et du fluor.
- Avantageusement, le CxHy est le CH4.
- Avantageusement, l'étape de formation du film carboné est réalisée en utilisant un plasma à couplage inductif (ICP) ou un plasma à couplage capacitif (CCP).
- Avantageusement, l'étape de formation du film carboné est réalisée par dépôt chimique en phase vapeur assisté par plasma (PECVD).
- Avantageusement, l'étape de retrait de la couche de protection modifiée est sélective de la couche de protection modifiée vis-à-vis de la couche active.
- Avantageusement, lors de l'étape de modification les conditions du plasma, en particulier la concentration, l'énergie des ions à base d'hydrogène (H, H⁺, H₂⁺, H₃⁺ etc.) et/ou à base d'hélium (He) et la direction principale d'implantation de ces ions sont choisies de manière à ce que, au niveau des surfaces perpendiculaires à la direction d'implantation, toute l'épaisseur de la couche de protection soit modifiée par l'implantation des ions du plasma de l'étape de modification et l'étape de retrait est réalisée de manière à retirer toute la couche de protection modifiée, mettant ainsi à nu la couche active au niveau des surfaces perpendiculaires à la direction d'implantation.
- Avantageusement, l'étape de retrait de la couche de protection modifiée est effectuée par gravure humide.
- Avantageusement, la gravure sélective au silicium est obtenue à l'aide d'une solution à base d'acide fluorhydrique (HF) ou de H3PO4.
- Avantageusement, le matériau semi-conducteur est du silicium et l'étape de retrait de la couche de protection modifiée est effectuée par gravure humide sélectivement audit matériau semi-conducteur de la couche active et/ou à une couche d'oxyde de silicium (SiO2) surmontant la grille.
- Alternativement, l'étape de retrait est effectuée par gravure sèche sélective de ladite couche de protection modifiée vis-à-vis dudit film carboné, vis-à-vis des portions non-modifiées de la couche de protection et vis-à-vis dudit matériau semi-conducteur. En outre la gravure sèche ne prélève pas non plus l'oxyde de silicium (SiO2) formant un masque dur au sommet de la grille.
- De préférence, le matériau semi-conducteur est du silicium, et l'étape de retrait de la couche de protection modifiée est effectuée par gravure sèche sélective au silicium (Si).
- Préférentiellement, la gravure sèche est effectuée dans un plasma formé dans une enceinte confinée à partir de trifluorure d'azote (NF3) et d'ammoniac (NH3).
- Avantageusement, l'implantation et le retrait de la couche de protection sont réalisés dans un même réacteur plasma. Une modification de la couche à retirer réalisée par une implantation par plasma permet ainsi d'effectuer la modification de la couche de protection et la gravure dans une même chambre ce qui est très avantageux en termes de simplification, de temps et de coût du procédé.
- Avantageusement, la gravure sèche comprend une étape de gravure consistant en la formation de sels solides ; et une étape de sublimation des espèces solides. Ce mode de réalisation permet d'obtenir une très bonne sélectivité de la gravure du nitrure modifié par rapport au nitrure non modifié et au matériau semi-conducteur non modifié. En particulier, cette sélectivité de la gravure est très supérieure (typiquement un facteur 10 au moins) à celle obtenue avec une solution de HF.
- Avantageusement, l'étape de modification de la couche de protection est effectuée après l'étape de formation du film carboné et après l'étape de retrait de portions du film carboné.
- Avantageusement, l'étape de modification de la couche de protection est effectuée préalablement à l'étape de formation du film carboné.
- De manière préférentielle mais non limitative, le procédé comprend plusieurs séquences comprenant chacune une étape de retrait du film carboné et/ou une étape de modification de la couche de protection et une étape de retrait, et au cours d'au moins l'une des étapes de modification, seule une partie de l'épaisseur de la couche de protection est modifiée.
- Les séquences sont de préférence répétées jusqu'à disparition de la couche de protection sur toutes les surfaces parallèles au plan d'un substrat sur lequel repose la grille.
- Dans un mode de réalisation, l'étape de modification est une unique étape effectuée de manière à modifier la couche de protection dans toute son épaisseur sur toutes les surfaces parallèles au plan d'un substrat sur lequel repose la grille et à ne pas modifier la couche de protection dans toute son épaisseur sur les surfaces perpendiculaires à ce plan. Ce mode de réalisation permet un contrôle particulièrement précis de la dimension des espaceurs.
- De manière préférentielle mais non limitative, l'étape de modification est précédée d'une étape de gravure anisotrope qui est effectuée dans un plasma de type CH3F/O2/He. Ce mode de réalisation permet d'enlever une épaisseur importante de la couche de protection en une étape puis d'affiner le contrôle de l'épaisseur sur les flancs au cours d'une deuxième étape. Ce mode de réalisation permet ainsi de réduire le temps de fabrication.
- Avantageusement, la grille du transistor est située sur un empilement de couches formant un substrat élaboré de type silicium sur isolant (SOI).
- Avantageusement, le matériau semi-conducteur est pris parmi: le silicium (Si), le germanium (Ge), le silicium-germanium (SiGe). L'étape de retrait de la couche à base de nitrure de silicium modifiée est effectuée par gravure humide sélectivement au Ge ou au SiGe ou et/ou à de l'oxyde de SiGe ou de l'oxyde de Ge.
- Avantageusement, l'étape de modification réalisée à partir d'un plasma modifie la couche de protection de manière continue depuis la surface de la couche à base de nitrure et sur une épaisseur comprise entre 1 nm et 30 nm et de préférence entre 1nm et 10 nm.
- Avantageusement, le transistor est un transistor de type FDSOI.

Comme on l'a vu un objet de l'invention est de s'affranchir de tous ou d'au moins certains des problèmes mentionnés ci-dessus.

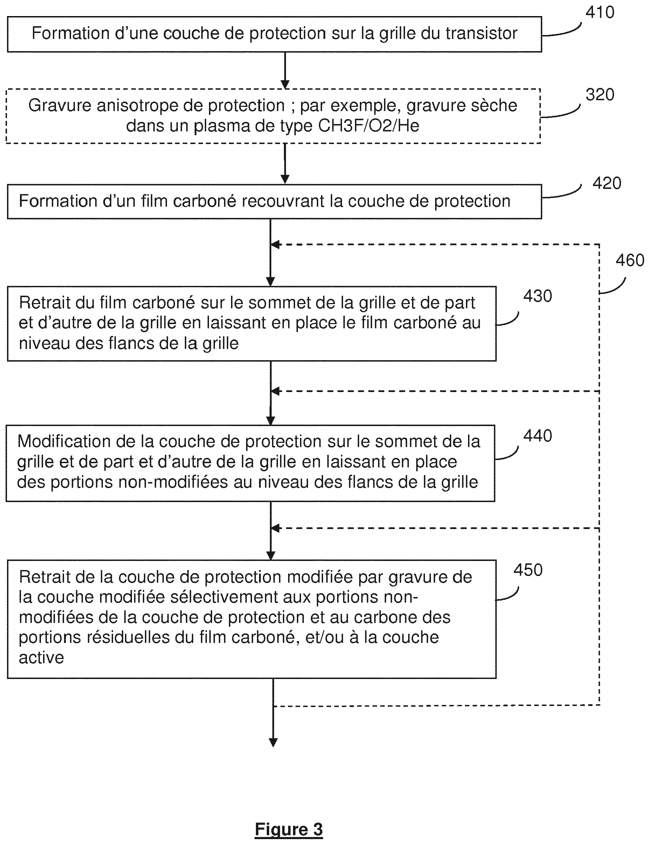

La **figure 3** résume les principales étapes 410 à 450 de plusieurs exemples détaillés de procédés selon l'invention de formation d'espaceurs d'un transistor. Ces étapes 410 à 450 peuvent également s'appliquer à la formation d'espaceurs sur les flancs des grilles de transistors variés : FDSOI ou autre. Les étapes 410 à 450 seront respectivement détaillées dans les paragraphes ci-dessous concernant les **figures 4a** à **4e****,** **5****,** **8a** à **8f** illustrant respectivement une structure d'un transistor 200 obtenue à l'issue d'une des étapes 410 à 450 selon un mode de réalisation de l'invention.

La **figure 4a** illustre une structure d'un transistor 200 formé sur un substrat 140 de type SOI comprennent une couche active 146 est surmontée d'une grille 120 du transistor 200.

La formation du transistor 200 consiste à réaliser un substrat élaboré 140 de type SOI, à partir d'un substrat 142, souvent désigné substrat massif (bulk substrat en anglais), une couche isolante initiale 144 et la couche active 146, cette dernière étant destinée à former ultérieurement un canal de conduction du transistor 200.

Alternativement, le matériau semi-conducteur est pris parmi: le germanium (Ge), le silicium germanium (SiGe).

En plus d'une couche de silicium polycristallin 123 on retrouve dans un empilement des couches formant la grille 120 tout d'abord une mince couche isolante d'oxyde de grille 121 à travers laquelle un champ électrique va pouvoir se développer pour créer un canal de conduction sous jacent entre source et drain quand une tension électrique suffisante est appliquée sur la grille 120. Dans les transistors MOSFET les plus récents il est mis en oeuvre une technologie qualifiée du vocable anglais de « high-k/metal gate » c'est-à-dire que la couche diélectrique 121 est faite d'un matériau isolant à haute permittivité (high-k) couverte par une couche métallique (metal gate ; non-illustrée en figures) de la grille 120. À ce stade, l'empilement de couches de la grille 120 comprend aussi un masque dur 126 de protection qui sera enlevé ultérieurement pour permettre la reprise de contact sur cette électrode. Ce masque dur 126, qui reste en place après gravure de la grille, est typiquement fait d'oxyde de silicium (SiO2). Son rôle est de protéger le sommet de la grille 120 de tout dommage lors de la réalisation des étapes suivantes et notamment celles de gravure des espaceurs.

De préférence, la couche diélectrique 121 est disposée au contact de la couche active 146 formant le canal de conduction. De préférence, la couche métallique est disposée au contact de la couche diélectrique 121. De préférence, la couche de silicium polycristallin 123 est disposée directement au contact de l'oxyde de grille formée par la couche diélectrique 121 si la couche métallique est absente ou est disposée directement au contact de la couche métallique.

La **figure 4b** illustre une structure obtenue à l'issue de l'étape de formation 410 d'une couche de protection 152 recouvrant le transistor 200.

L'étape de formation 410 de la couche de protection 152, d'épaisseur préférentiellement sensiblement constante, est effectuée de manière à recouvrir le transistor 200, c'est-à-dire sur toutes les surfaces, verticales et horizontales, des dispositifs en cours de fabrication. Il s'agit ainsi d'un dépôt de préférence conforme. De manière préférentielle mais non limitative, la couche de protection 152 est disposée directement au contact des surfaces des structures en cours de fabrication.

Cette étape de formation 410 se fait de préférence à l'aide d'une méthode de dépôt dite LPCVD, acronyme de l'anglais « low pressure chemical vapor déposition », c'est-à-dire « dépôt chimique en phase vapeur à faible pression ». Ce type de dépôt qui se pratique à pression atmosphérique permet en effet un dépôt uniforme sur toutes les surfaces quelle que soit leur orientation.

La couche de protection 152 est de préférence une couche de nitrure de silicium d'un composé chimique Si3N4 ou SiN. Dans un autre mode de réalisation, la couche de protection 152 est une couche dont le matériau présente une constante diélectrique égale ou inférieure à celle du nitrure de silicium, tel que le nitrure de bore (BN), le SiCBN, le SiOCN, le SiCO, le SiC, etc. Ces matériaux présentant une faible constante diélectrique permettent de de réduire capacité parasite pour éventuellement améliorer la performance du transistor.

De préférence, le matériau de la couche de protection 152 est compatible avec un nettoyage par voie sèche ou humide réalisé à une étape suivante 450 pour enlever une couche de protection modifiée 158 (décrite ultérieurement).

L'épaisseur de la couche de protection 152 est de préférence suffisamment importante, pour que après la réalisation des étapes de modification 470 et de retrait 450 (décrites ultérieurement), il reste des portions non-modifiées 152a, 152b de la couche de protection 152 au niveau des flancs de la grille 120.

Dans un mode de réalisation préféré, l'épaisseur de la couche de protection 152 est comprise entre 5 nanomètres (nm) et 30 nm, de préférence 10 nm.

La **figure 4c** illustre la structure du transistor 200 à l'issue d'une étape de formation 420 d'un film carboné 217.

L'étape de formation 410 du film carboné 217, d'épaisseur préférentiellement sensiblement constante, est effectuée de manière à recouvrir le transistor 200, c'est-à-dire sur toutes les surfaces, verticales et horizontales, des dispositifs en cours de fabrication. Il s'agit ainsi d'un dépôt de préférence conforme. De manière préférentielle mais non limitative, le film carboné 217 est disposé directement au contact des surfaces des structures en cours de fabrication.

L'étape de formation 420 du film carboné 217 est effectuée par l'utilisation d'un réacteur de gravure tel que le CxHyFz, CxHy or CxFy où x est la proportion de carbone, y et/ou z sont respectivement la proportion d'hydrogène ou/et du fluor, afin de former un film carboné 217. Le carbone du film carboné 217 provient du réacteur de gravure.

De manière préférentielle, le réacteur de gravure est un gaz réactif à base de méthane (CH4).

On notera ici que l'étape de formation 420 du film carboné 217 peut se pratiquer de nombreuses façons différentes en adaptant toutes sortes de moyens couramment employés par l'industrie de la microélectronique, telles qu'à l'aide de tout type graveur, par exemple dans un réacteur ICP de l'anglais « Inductively Coupled Plasma » c'est-à-dire « plasma à couplage inductif », ou dans un réacteur de type CCP de l'anglais « Capacitive Coupled Plasma » c'est-à-dire « plasma à couplage capacitif » qui permet de contrôler l'énergie des ions.

Dans un autre mode de réalisation, le film carboné 217 obtenu à l'issue de l'étape de formation 420 du film carboné est formé à l'aide d'une méthode de dépôt dite PECVD, acronyme de l'anglais « Plasma-Enhanced Chemical Vapor Déposition », c'est-à-dire « dépôt chimique en phase vapeur assisté par plasma ». Ce type de dépôt qui se pratique à pression atmosphérique permet en effet un dépôt uniforme sur toutes les surfaces quelle que soit leur orientation. On obtient ainsi un dépôt de préférence conforme.

Le film carboné 217 obtenu est d'épaisseur préférentiellement sensiblement uniforme, sur toutes les surfaces des dispositifs en cours de fabrication. Selon le présent mode de réalisation préférentiel mais non limitatif, le film carboné 217 est disposé directement au contact de la couche de protection 152.

De préférence, l'épaisseur du film carboné 217 est comprise entre 0.5 et 10nm et de préférence entre 1 nm et 5 nm afin d'avoir une épaisseur totale d'espacement, définie par l'ensemble du film carboné 217 et de la couche de protection 152, formée d'entre 9 nm et 15 nm.

La **figure 4d** illustre la structure du transistor 200 à l'issue de deux étapes comprenant une étape de retrait 430 de portions du film carboné 217 et une étape de modification 440 de la couche de protection 152.

Selon un mode de réalisation avantageux mais non limitatif, ces deux étapes 430 et 440 sont réalisées simultanément. Dans d'autres modes de réalisation (décrits ultérieurement), les étapes 430 et 440 sont réalisées successivement.

De plus, dans un autre mode de réalisation (décrit ultérieurement), les étapes 420, 430 et 440 peuvent être réalisées dans un ordre différent de celui des étapes 420 à 440 du présent mode de réalisation illustré en **figures 4a** à **4e****.**

Dans le présent mode de résiliation, ces étapes 430 et 440 peuvent, comme l'étape de formation 420 du film carboné mentionnée précédemment, se faire de plusieurs manières telles qu'à l'aide de tout type graveur, par exemple ICP, CCP, ou à l'aide d'une méthode de dépôt de type PECVD.

On notera ici que ces étapes 430 et/ou 440 peuvent se pratiquer de nombreuses façons différentes en adaptant toutes sortes de moyens couramment employés par l'industrie de la microélectronique. On utilise notamment des gravures standard dont lesquels on peut développer des plasmas à faible ou haute densité et où on peut contrôler l'énergie des ions (comme le CCP) pour permettre l'implantation des espèces destinées à modifier la couche de protection 152 à graver ultérieurement lors d'une étape 450. On peut aussi utiliser un type de plasma dit par immersion couramment utilisé pour pratiquer une implantation d'espèces en surface d'un dispositif en cours de fabrication.

De manière avantageuse, l'équipement utilisé pour (ICP, CCP, PECVD par exemple) effectuer l'étape de formation 420 du film carboné est également utilisé pour réaliser l'étape de retrait 430 et/ou l'étape de modification 440 de la couche de protection 152.

Selon le présent mode de réalisation non limitatif, les étapes 430 et 440 se font par mise en présence du film carboné 217 ainsi que de la couche de protection 152 avec un plasma comprenant des espèces telles que l'hydrogène (H2) et/ou l'hélium (He). De manière alternative et préférentielle, ledit plasma comprend, en plus de H2 ou/et He, des ions lourds tels que l'azote (N2), l'argon (Ar), le xénon (Xe) ou/et l'Oxygène (O2).

Plus précisément, les espèces du plasma tel que ci-dessus remplissent au moins l'une de deux fonctions ci-dessous :
« a » (étape de retrait 430) Retrait de portions du film carboné 217 réalisé, préférentiellement de manière anisotrope, de sorte à enlever des portions du film carboné 217 qui sont perpendiculaires aux flancs de la grille 120 en laissant en place des portions résiduelles 217a, 217b du film carboné 217 au niveau des flancs de la grille 120 ;
« b » (étape de modification 440) Modification de la couche de protection 152 réalisée, préférentiellement de manière anisotrope, de sorte à former une couche de protection modifiée 158 en modifiant des portions de la couche de protection 152 qui sont perpendiculaires aux flancs de la grille 120 et en conservant des portions non-modifiées 152a, 152b de la couche de protection 152 recouvrant les flancs de la grille 120. Ainsi la couche de protection 152 située sur le sommet de la grille 120 et de part et d'autre de la grille 120 est modifiée. La couche de protection 152 située sur les flancs de la grille 120 n'est pas modifiée.

Pour remplir la fonction ci-dessus « a », le plasma comprend de manière générale de l'hydrogène ou des ions plus lourds que l'hydrogène tels que l'hélium (He), l'argon (Ar), l'azote (N2), et l'oxygène (O2). Par souci de concision, ces ions sont désignés dans la suite de la description « ions lourds ».

Plus précisément, les ions lourds du plasma pulvérisent les espèces carbonées du film carboné 217 (formé à l'issue de l'étape 420) sur les parois perpendiculaires à la direction d'implantation, telles que sur les surfaces de la couche de protection 152 recouvrant la couche active 146 et le masque dur 126 au sommet de la grille 120. En revanche, sur les surfaces qui reçoivent un bombardement d'ions moindre ou qui ne reçoivent pas de bombardement d'ions, telles que sur les surfaces de la couche de protection 152 au niveau des flancs de la grille 120, ce film carboné 217 reste en place.

La nature des ions lourds et les paramètres du plasma, en particulier son énergie, permettent d'assurer une déplétion des groupements méthyles du film carboné 217 réalisée de manière anisotrope, de sorte que des portions du film carboné 217 qui sont perpendiculaires aux flancs de la grille 120 soient enlevées. La fonction « a » est donc assurée.

Dans un mode de réalisation préférentiel, le plasma comprend de l'hélium (He) car He est particulièrement efficace pour assurer la fonction « a ». De préférence, le plasma comprenant de l'He est utilisé à basse énergie comprise entre 20eV et 500eV afin d'à la fois d'assurer une déplétion des groupements pour enlever le film carboné 217 (étape 430) et de ne pas modifier totalement la couche de protection 152 (étape 440).

Dans un autre mode de réalisation où l'Argon est le seul type d'ions lourds contenu dans le plasma, l'Argon permet, éventuellement à lui seul, l'enlèvement des portions du film carboné 217 sur les surfaces perpendiculaires à la direction de bombardement. Combiné à He, N2 et/ou O2 il contribue à pulvériser le film carboné 217 et ainsi à l'enlever.

Par conséquent, à l'issue de l'étape de retrait 430, il ne reste que les portions résiduelles 217a, 217b du film carboné 217 au niveau des flancs de la grille 120. Les portions résiduelles 217a, 217b deviendront donc des espaceurs carbonés 217a, 217b qui protégeront les flancs de la grille 120 de l'attaque de la solution HF par exemple, lors de la réalisation de l'étape de retrait 450 de la couche de protection modifiée 158 qui sera décrite ultérieurement.

On notera que de manière particulièrement avantageuse, le film carboné 217 agit comme un protecteur pour la couche de protection 152 qu'il recouvre, réduisant l'épaisseur sur laquelle les ions à base d'hydrogène (H, H⁺, H₂⁺, H₃⁺ etc.) et/ou à base d'hélium (He) pénètrent dans la couche de protection 152 et modifient cette dernière lors de l'étape de modification de la couche de protection 152. Ainsi, le film carboné 217 permet d'augmenter la différence d'épaisseur de modification entre les surfaces recouvertes par le film carboné 217 et les surfaces qui ne le sont pas. On contrôle ainsi encore mieux l'épaisseur modifiée et donc l'épaisseur gravée de la couche de protection 152.

La fonction « b » est assurée par des ions à base d'hydrogène ou/et d'hélium, typiquement l'ion hydrogène (H) ou/et l'ion hélium (He). Ces ions ont pour propriété de pénétrer facilement et en profondeur dans la couche de protection 152 et modifient ainsi cette dernière. Par rapport aux espèces He, les espèces H2 fonctionnent plus efficacement car elles modifient la couche de protection 152 mais sans la pulvériser.

Le plasma de l'étape de modification 440 de la couche de protection 152 peut ainsi être formé à partir d'un gaz à base de He et/ou d'hydrogène tel que le NH3 ou HBr par exemple.

Par rapport à l'utilisation d'une seule type d'espèces He, la combinaison des espèces He et H2 permet de réduire l'énergie des ions et d'avoir une meilleure précision de l'épaisseur de la couche de protection 152 à modifier et à graver. De plus, ladite combinaison des espèces He et H2 permet de réduire le risque d'amorphisation du Si ou du SiGe.

On notera que dans les modes de réalisation dans lesquels le plasma de l'étape de modification 440 de la couche de protection 152 comprend les ions légers à base d'hydrogène (H, H⁺, H₂⁺, H₃⁺ etc.) et/ou à base d'hélium (He) et des ions lourds (He, Ar, N2, Xe ou O2 par exemple), les ions légers participent en synergie avec les ions lourds du plasma à la modification de la couche de protection 152. Les ions lourds permettent de renforcer l'action des ions légers mais ils pénètrent eux-mêmes beaucoup moins profondément dans la couche de protection 152. Ces ions lourds restent localisés en surface de la couche de protection 152 et ne sont donc pas aptes à modifier une épaisseur importante, et a fortiori toute l'épaisseur, de la couche de protection 152. La profondeur de pénétration des ions lourds est environ dix fois plus faible que la profondeur de pénétration des ions légers. La profondeur de pénétration de ces ions lourds et identique voire inférieure à la profondeur sur laquelle le matériau de la couche de protection 152 est pulvérisé. Typiquement avec des ions argons (Ar) on a une pénétration de 1nm dans le nitrure pour une énergie de 300eV, or dans le même temps le taux de pulvérisation est de 1-2nm.

Plus précisément, les ions à base d'hydrogène et/ou d'hélium peuvent être implantés dans le matériau à graver, sans provoquer de dislocation de sa structure atomique telle qu'elle entraînerait une pulvérisation de ce dernier, et donc sans redépôt du matériau gravé sur les parois du réacteur ou les motifs en cours de gravure eux-mêmes, sont susceptibles de convenir.

Cette étape de modification 440 de la couche de protection 152 est réalisée pour que le plasma soit anisotrope de manière à bombarder les ions dans une direction privilégiée parallèle aux flancs de la grille 120. Le plasma utilisé lors de cette étape 440 créé un bombardement d'ions s'implantant au moins dans une portion supérieure de l'épaisseur de la couche de protection 152 au niveau des surfaces perpendiculaires aux flancs de la grille 120.

L'étape de modification 440 est effectuée par une implantation à l'aide d'un plasma a pour avantage de permettre une implantation en continue depuis la surface libre de la couche de protection 152 et sur une épaisseur faible, typiquement comprise entre 0 et 100 nm voire entre 0 et 30 nm. Elle permet également de bénéficier d'une sélectivité améliorée dès le début de la gravure et d'une vitesse de gravure constante, conduisant à une précision de gravure améliorée.

L'emploi d'un plasma pour implanter la couche de protection 152 permet ainsi de retirer une couche très fine, typiquement comprise entre 1 et 10 nm et plus généralement entre 1 et 30 nm.

Les ions à base d'hydrogène sont de préférence pris parmi : H, H+, H2+, H3+. Dans la suite de la description, et par souci de concision, on désignera les ions à base d'hydrogène « ions hydrogène ».

Ainsi, les ions modifient les surfaces perpendiculaires à la direction du bombardement telles que la surface au sommet de la grille 120 et les surfaces de la couche de protection 152 recouvrant la couche active 146. En revanche, les surfaces parallèles à la direction du bombardement, c'est-à-dire l'épaisseur de la couche de protection 152 au niveau des flancs de la grille 120, sont protégées par les espaceurs carbonés 217a, 217b et ne sont donc pas modifiée. Comme mentionné précédemment, une épaisseur non modifiée 152a, 152b recouvrant les flancs de la grille 120 est conservée. Ces portions non-modifiées 152a, 152b deviendront des espaceurs de protection 152a, 152b.

Il faut noter que lors de l'étape 440 de modification de la couche de protection 152, on évite d'utiliser le CxHy tel que le CH4 afin de ne pas risquer d'implanter des espèces carbonées dans la couche active par exemple en Si ou le SiGe ou dans le substrat 140.

Ainsi, à l'issue des étapes 430 et 440, le film carboné 217 formé recouvre seulement les surfaces qui sont perpendiculaires ou fortement inclinées par rapport au plan du substrat 140, telles que les surfaces supérieures de la couche de protection modifiée 158 au niveau des flancs de la grille 120.

Pour choisir les paramètres d'implantation l'homme du métier, afin de déterminer le comportement du matériau à graver dans le type d'implanteur choisi, procédera préalablement de préférence à des essais « pleine plaque » afin d'établir des courbes de comportement. Il en déduira les paramètres de l'implantation, en particulier l'énergie et la dose d'ions, c'est-à-dire le temps d'exposition, à utiliser pour atteindre l'épaisseur voulue de matériau à modifier.

A titre d'exemple, le tableau ci-après donne des conditions typiques de mise en oeuvre de l'étape de retrait 430 du film carboné 217 ainsi que de l'étape de modification 440 de la couche de protection 152, réalisées par utilisation d'un plasma de He/H2, en fonction du temps en secondes et de la puissance de la polarisation (bias) en watts, etc. Ces conditions sont largement dépendantes de l'épaisseur à modifier de la couche de protection 152 et/ou celle à enlever du film carboné 217.

| Réacteur de gravure : | plasma à couplage inductif de He/H2 (He : 50 - 500 sccm, H2 : 10 - 500 sccm) |
|---|---|
| Épaisseur de la couche de protection 152 à modifier (épaisseur de la couche de protection modifiée 158) : | 1 - à quelques dizaines de nm |
| Puissance de la source : | 0 - 2000 Watts |
| Puissance de polarisation (énergie des ions) : | 20 - 500 V |
| Pression : | 5 milli Torr- 10 milli Torr |
| Température : | 10 - 100 °C |
| Temps : | quelques secondes à quelques centaines de secondes |

Un exemple plus précis de mise en oeuvre de l'étape de modification 440 permettant de modifier une épaisseur de 15 mm de la couche de protection 152 de nitrure, réalisé par utilisation d'un plasma de He, est décrit dans le tableau ci-dessous:

| Réacteur de gravure : | plasma à couplage inductif de He (He : 250 sccm) |
|---|---|
| Épaisseur de la couche de protection 152 à modifier (épaisseur de la couche de protection modifiée 158): | 15 nm |
| Puissance de la source : | 500 W |
| Puissance de polarisation (énergie des ions) : | 350 V |
| Pression : | 10 milli Torr |
| Température : | 60°C |
| Temps : | 60 secondes |

Préférentiellement, la couche de protection 152 est modifiée sur toute son épaisseur au-dessus de la grille 120 et au-dessus de la couche active 146 est tout en laissant en place des portions non-modifiées 152a, 152b de la couche de protection 152 au niveau des flancs de la grille 120.

La **figure 4e** illustre le résultat de l'étape de retrait 450 de la couche de protection modifiée 158 après que l'on ait procédé à une opération de gravure sélective de la couche de protection modifiée 158 par rapport : au film carboné 217, aux portions non-modifiée 152a, 152b de la couche de protection 152 et à la couche active 146. L'invention permet d'éviter de consommer la couche de protection 152 située sur les flancs de la grille 120 du fait de la sélectivité de la gravure et du fait de la protection assurée par le film carboné 217.

La solution de gravure grave ainsi la couche de protection modifiée 158 à laquelle elle a directement accès sur le sommet de la grille 120 et de part et d'autre de la grille 120. La solution de gravure consomme ainsi la couche de protection modifiée 158.

Dans un mode de réalisation préférentiel, les espaceurs carbonés 217a, 217b restent en place ; c'est-à-dire il qu'y a deux couches d'espaceurs - les espaceurs carbonés 217a, 217b et les espaceurs de protection 152a, 152b - utilisées pour protéger les flancs de la grille 120.

Avantageusement, les paramètres de l'étape de retrait 450 de la couche de protection modifiée 158 sont également réglés de manière à ce que la couche de protection modifiée 158 puisse être gravée sélectivement par rapport à une couche faite d'un oxyde typiquement un oxyde dudit matériau semi-conducteur, cette dernière formant par exemple une couche d'oxyde de grille. Typiquement, la gravure sélective de la couche de protection modifiée 158 ne consomme pas l'oxyde de silicium SiO2.

Avantageusement, ces paramètres sont également réglés de manière à ce que la couche de protection modifiée 158 puisse être gravée sélectivement par rapport au matériau semi-conducteur de la couche active 146.

Dans un mode de réalisation préférentiel dont la couche de protection modifiée 158 est de silicium, l'étape de retrait 450 est effectuée par gravure humide en utilisant une solution de gravure à base d'acide fluorhydrique (HF) ou d'acide phosphorique (H3PO4).

Pour éviter les problèmes des procédés conventionnels de gravure des espaceurs décrits dans les **figures 2a à 2c****,** il est nécessaire que la gravure de la couche de protection modifiée 158 soit la plus sélective possible par rapport au silicium notamment afin de ne pas attaquer le silicium de la couche active 146. Par exemple, dans ce mode de réalisation de gravure humide, il n'y a aucune consommation de silicium de la couche active 146 due à l'utilisation de la solution gravure à base d'acide fluorhydrique (HF).

Comme mentionné ci-dessus, l'épaisseur de la couche de protection modifiée 158 est typiquement comprise dans une gamme de valeurs allant de 1 nm à quelques dizaines de nm. Les temps de gravure peuvent aller de quelques secondes à quelques minutes en étant évidemment directement dépendants de l'épaisseur qui a été modifiée.

À titre d'exemple dans lequel la couche de protection modifiée 158 est une couche de nitrure modifié, pour enlever une épaisseur modifiée comprise entre 5 nm et 20 nm de nitrure modifié il faut de l'ordre de 30 secondes avec une solution d'acide fluorhydrique (HF) à 1%. Le même temps de gravure est obtenu avec de l'acide phosphorique dilué (H3PO4) à 85%.

L'arrêt de ladite gravure sélective peut donc se faire sur les portions-non modifiées 152a, 152b de la couche de protection 152 ou/et sur le silicium monocristallin de la couche active 146 ou/et encore sur le masque dur 126 au sommet de la grille 120, jusqu'à la disparition de la couche de protection modifiée 158.

Pour le retrait de la couche de protection modifiée 158, on a de préférence recourt à une gravure humide qui combine le retrait de la couche de protection modifiée 158 avec un nettoyage humide de la tranche contenant les dispositifs en cours de fabrication, car après cette gravure humide, conventionnellement un nettoyage humide (traduction de l'anglais « wet clean ») est réalisé pour nettoyer un wafer sur lequel est le transistor 200.

De préférence, cette gravure humide est combinée avec le nettoyage humide, ce qui simplifie le procédé et apporte un gain de temps.

Les paramètres du nettoyage humide sont également réglés de manière à ce que la couche de protection modifiée 158 puisse être gravée très sélectivement par rapport aux espèces contenant du carbone du film carboné 217, et aux portions non-modifiées (les espaceurs de protection obtenus) 152a, 152b de la couche de protection 152.

Alternativement à une gravure humide, une gravure sèche de la couche de protection modifiée 158 sélectivement au silicium de la couche active 146, au matériau des espaceurs de protection 152a, 152b, à l'oxyde de silicium (SiO2) du masque dur 126 pourra alors être aussi pratiquée pour cette étape de retrait 440 par voie sèche de la couche de protection modifiée 158.

Les modes de réalisation pour le retrait par HF d'une couche de protection modifiée 158 de nitrure de silicium s'appliquent également dans les cas où la couche de protection 152 est d'une autre nature, notamment dans le cas où le matériau de la couche de protection 152 présente une constante diélectrique inférieure à celle du nitrure de silicium, tel que le nitrure de bore (BN), le SiCBN, le SiOCN, SiCO, SiC.

Selon un mode de réalisation préférentiel, la couche de protection modifiée 158 est du nitrure de silicium. Le principe du retrait par voie sèche de la couche de protection modifiée 158 comprend les étapes suivantes 610 à 630 illustrées en **figure 6** qui s'effectuent dans une chambre de réaction où l'on forme un plasma. Les épaisseurs traitées sont typiquement comprises entre 1 nm et quelques dizaines de nanomètres.

La méthode est celle décrite par H. Nishini et ses coauteurs dans une publication en anglais intitulée « Damage-free selective etching of Si native oxides using NH3/NF3 and SF6/H2O down flow etching » parue dans le « Journal of Applied Physics » volume 74 (2), en juillet 1993.

Le principe du retrait par voie sèche de la couche de nitrure de silicium est proche de celui décrit dans la publication ci-dessus. La différence est que dans le cas de l'invention on ne grave pas de l'oxyde de silicium mais la couche 158 modifiée par utilisation d'un plasma de type par exemple H2/CH4/Ar.

Le mécanisme est toutefois le même et comprend les étapes suivantes qui s'effectuent dans une chambre de réaction où l'on forme un plasma. Une première étape 610 consiste à générer le produit de gravure dans le plasma selon la réaction chimique suivante :

NF₃+NH₃ → NH₄F + NH₄F.HF

qui fait réagir du trifluorure d'azote (NF₃) avec de l'ammoniac (NH₃).

La gravure se fait au cours d'une deuxième étape 620, à une température de l'ordre de 30°C et plus généralement entre 10°C et 50°C, sous la forme d'une formation de sels selon la réaction chimique suivante :

NH₄F or NH₄F.HF + SiNH → (NH₄)2SiF₆ (solide) + H₂

au cours d'une opération qui dure entre quelques secondes et quelques minutes et qui s'effectue sous une pression comprise entre quelques milli Torr et quelques Torr. Plus précisément, cette opération dure entre 20 secondes et 2 minutes et s'effectue sous une pression comprise entre 500 milli Torr et 3 Torrs.

Les espèces solides qui sont formées au cours de cette opération sont ensuite sublimées 630 à une température supérieure à 100°C pendant quelques dizaines de secondes selon la réaction suivante :

(NH₄)2SiF₆ (solid) → SiF₄(g) + NH₃(g) + HF(g)

Par exemple, pour enlever une couche de 10 nm de nitrure modifié les flux de trifluorure d'azote (NF₃) et d'ammoniac (NH₃) sont respectivement de 50 sccm et de 300 sccm à 30°C pendant 45 secondes pour l'étape 620 de formation des sels qui est suivie par l'étape de sublimation 630 qui s'effectue à 180°C pendant 60 secondes.

Ce mode de réalisation permet d'obtenir une très bonne sélectivité de la gravure du nitrure modifié par rapport au nitrure non modifié et au matériau semi-conducteur non modifié. En particulier, cette sélectivité de la gravure est très supérieure (typiquement un facteur 10 au moins) à celle obtenue avec une solution de HF.

À l'issue de l'étape de retrait 450, il ne reste donc que les portions non- modifiées 152a, 152b de la couche initiale de protection 152 essentiellement sur les flancs de l'empilement de couches qui forment la grille 120. Ces portions non-modifiées 152a, 152b constituent les espaceurs de protection 152a, 152b pour la grille 120 du transistor 200 par exemple de de type FDSOI. De plus, la gravure de la couche de protection modifiée 158 peut être également réalisée pour la réalisation des espaceurs d'un transistor tridimensionnel de type FinFET.

Le résultat de la **figure 4e** peut être le résultat d'une seule étape de modification et d'une seule étape de retrait ou d'une pluralité de séquence comprenant ces étapes. En effet, les opérations de modification 440 de la couche de protection 152, et de retrait 450 de la couche de protection modifiée 158 peuvent optionnellement être répétées 460. Les séquences comprenant chacune une étape de retrait 430 et/ou une étape de modification 440 et une étape de retrait 450 sont réalisées jusqu'à enlèvement complet du matériau modifié (du nitrure modifié par exemple) de la couche de protection modifiée 158. Le nombre de séquences est calculé en fonction de la vitesse de gravure de la première séquence.

Sur l'exemple illustré, les portions résiduelles 217a, 217b du film carboné 217 sont conservées. Selon un mode de réalisation alternatif elles sont retirées. A cette fin on utilisera les techniques décrites précédemment à propos de l'étape 430 de retrait de portions du film carboné 217. Dans ce cas pour retirer le film carboné 217 sur les flancs on peut utiliser un plasma sans bias. Pour ne pas endommager le Si ou le SiGe, on peut utiliser un plasma type O2 ou N2/H2.

Des étapes additionnelles peuvent par exemple être des étapes standard où l'on réalise possiblement les extensions des zones source/drain par implantation ionique de dopants avant croissance épitaxiale des source/drain surélevés de transistors FDSOI.

Selon un mode de réalisation particulier, on notera que le procédé de l'invention peut optionnellement comprendre, après l'étape de formation 410 de la couche de protection 152 et préalable à l'étape de formation 420 d'un film carboné 217, une gravure anisotrope 320 de la couche de protection 152. Ceci est typiquement effectué dans un plasma de type CH3F/O2/He décrit précédemment. La gravure des espaceurs est ainsi, selon ce mode de réalisation optionnel et non limitatif, réalisée en deux étapes comprenant : une première étape dite de « gravure principale » réalisée de manière isotrope, et une seconde étape de finition généralement qualifiée de « surgravure » ou du terme anglophone de « over etching (OE) » ayant la même signification. C'est au cours de l'étape de surgravure (étapes 450) que l'on finira d'enlever le matériau restant sur les surfaces horizontales, après avoir modifié (étape 440) la couche de protection 152 pour éviter ou limiter les problèmes décrits dans les **figures 2a** à **2c****.**

Dans le cadre de la mise en oeuvre de l'invention on peut décider de maintenir ou non l'étape de gravure anisotrope 320, les étapes suivantes s'appliquent alors soit sur la couche de protection 152 telle que déposée ou sur la couche restante de la couche de protection 152 après qu'une gravure principale a été préalablement effectuée comme dans le procédé standard de gravure des espaceurs.

L'étape de gravure anisotrope 320 permet d'enlever rapidement une forte épaisseur de nitrure par la gravure isotrope puis de contrôler avec précision l'épaisseur des espaceurs en effectuant les étapes 440 et 450.

Cette étape 320 peut être appliquée à toutes les variantes de réalisation l'invention, notamment celles qui seront décrites par la suite.

Un mode de réalisation alternatif selon l'invention va maintenant être décrit en détail en référence aux **figures 4a** à **4c****,** **5, 4d** et **4e****.**

La structure de départ du transistor 200 selon ce mode de réalisation alternatif est similaire à celle du transistor 200 tel qu'illustrée en **figure 4a****.**

L'étape de formation 410 d'une couche de protection 152 n'est pas différente de celle illustrée précédemment en référence au mode de réalisation décrit en figure **4b****.**

La description détaillée de la structure de départ du transistor 200 et de l'étape de formation 410 est par conséquent omise afin d'éviter une description redondante.

L'étape suivante à réaliser est l'étape de formation 420 d'un film carboné 217. Cette étape 420 n'est pas différente de celle illustrée précédemment en référence au mode de réalisation décrit en **figure 4c****.**

Une des différences principales entre le mode de réalisation décrit en **figures 4a à 4e** et le présent mode de réalisation alternatif réside dans les étapes de retrait 430 de portions du film carboné 217 et de modification 440 de la couche de protection 152. Les étapes 430 et 440 du mode de réalisation décrit en **figures 4a à 4e** sont réalisées simultanément alors que selon cet autre mode de réalisation, l'étape de retrait 430 de portions du film carboné est effectuée préalablement à l'étape de modification 440 de la couche de protection 152.

La **figure 5** montre la structure du transistor 200 obtenue à l'issue de l'étape de retrait 430 selon le présent mode de réalisation alternatif.

Selon ce mode de réalisation, l'étape de retrait 430 est une unique étape effectuée pour enlever, préférentiellement de manière anisotrope, le film carboné 217 dans toute son épaisseur sur toutes les surfaces parallèles au plan du substrat 140 sur lequel repose la grille 120 du transistor 200 en conservant des portions résiduelles 217a, 217b au niveau des flancs de la grille 120. Ainsi les portions du film carboné 217 se trouvant sur le sommet de la grille 120 et de part et d'autre de la grille 120 sont retirées.

Le type de plasma utilisé et les conditions de réalisation de mise en oeuvre de cette étape de retrait 430 sont similaires à ceux de l'étape 430 du mode de réalisation illustrée précédemment en **figures 4a** à **4e****.** La fonction « a » telle que décrite précédemment est donc remplie.

De manière préférentielle, la couche de protection 152 n'est pas modifiée lors de cette étape de retrait 430. Afin d'enlever le film carboné 217 sans modifier la couche de protection 152, on peut utiliser des ions tels que Ar, N2, He. A noter que pour He il existe un risque de modification de la couche 152 car la profondeur d'implantation est plus importante qu'avec l'argon Ar par exemple pour une même énergie ionique. Dans de nombreuses applications, ce n'est pas gênant de modifier partiellement la couche de protection 152, à partir du moment où la couche sous-jacente, typiquement en Si ou en SiGe, n'est pas modifiée.

Ainsi, à l'issue de cette étape de retrait 430 des portions horizontales du film carboné 217, il ne reste que les portions résiduelles 217a, 217b du film carboné 217 qui recouvrent seulement les surfaces perpendiculaires au plan du substrat 140 (soit parallèle à la direction d'implantation du plasma lors de l'étape 430), par exemple au niveau des flancs de la grille 120.

Ces portions résiduelles 217a, 217b, servant d'espaceurs carbonés, présentent une épaisseur de préférence très fine, par exemple comprise entre 1 et 5 nm, de préférence 1 nm.

Comme le mode de réalisation illustré précédemment en **figures 4a** à **4e****,** le film carboné 217 n'est plus présent sur les surfaces perpendiculaires à la direction de bombardement, le bombardement d'ions étant réalisé de manière anisotrope comme mentionné précédemment.

Ensuite, l'étape de modification 440 est effectuée pour modifier, préférentiellement de manière anisotrope, la couche de protection 152 sur toutes les surfaces parallèles au plan du substrat 140 sur lequel repose la grille 120 du transistor 200 en conservant des portions non-modifiées 152a, 152b recouvrant les flancs de la grille 120, comme illustré en **figure 4d****.**

Le type de plasma utilisé et les conditions de réalisation de mise en oeuvre de cette étape de modification 440 de la couche de protection 152 sont similaires à ceux de l'étape 440 du mode de réalisation illustrée précédemment en **figures 4a** à **4e****.** La fonction « b » telle que décrite précédemment est donc remplie.

Ainsi, à l'issue de cette étape de modification 440 de la couche de protection 152, il ne reste que les portions non-modifiées 152a, 152b de la couche de protection 152 recouvrant seulement les surfaces perpendiculaires au plan du substrat 140, par exemple au niveau des flancs de la grille 120.

Ces portions non-modifiées 152a, 152b, servant d'espaceurs de protection, présentent une épaisseur de préférence fine, par exemple comprise entre 1 et 30 nm, de préférence 10 nm.

Comme le mode de réalisation illustré précédemment en figures **4a** à **4e****,** préférentiellement toute l'épaisseur de la couche de protection 152 sur les surfaces perpendiculaires à la direction de bombardement d'ions H2 et/ou He est modifiée.

Ensuite, l'étape de retrait 450 est effectuée pour enlever, la couche de protection modifiée 158, comme illustré en **figure 4e****.** Cette étape de retrait 450 est réalisée par gravure sélectivement aux portions non-modifiées 152a, 152b de la couche de protection 152 et au matériau semi-conducteur de la couche active 146. De préférence cette gravure grave la couche de protection modifiée 158 sélectivement aux espaceurs carbonés 217a, 217b et/ou à l'oxyde de silicium (SiO2) du masque dur 126 au sommet de la grille 120. Cette étape de retrait 450 peut être combinée avec une étape standard de nettoyage pour simplifier le procédé, ce qui permet d'apporter un gain de temps.

Le type de gravure sélective et les conditions de réalisation de mise en oeuvre de cette étape de retrait 450 sont similaires à ceux de l'étape 450 du mode de réalisation illustré précédemment en **figures 4a** à **4e****.**

De plus, selon ce mode de réalisation alternatif, le résultat de la **figure 4e** peut être le résultat d'une seule étape de modification 440 et d'une seule étape de retrait 450 ou d'une pluralité de séquence comprenant ces étapes.

En effet, les opérations de modification 440 de la couche de protection 152 et de retrait 450 de la couche de protection modifiée 158, peuvent optionnellement être répétées 460. Pour certaines applications il est nécessaire d'avoir un contrôle très précis du « facettage », c'est-à-dire du problème exposé dans la figure 2c, qui résulte des opérations de gravure conventionnelle et qui peut donc peut être induit par l'étape de gravure principale 320 qui est comme on l'a vu optionnelle. Avantageusement, pour pallier ce problème, on évitera donc cette étape qui sera remplacée par une répétition 460 des opérations de modification 440 de la couche de protection 152 et de retrait 450 de la couche de protection modifiée 158, le retrait se faisant de préférence dans ce cas sous la forme d'un retrait par voie sèche comme décrit dans la **figure 6** puisque, comme on la remarqué plus haut, les deux opérations peuvent se pratiquer dans le même réacteur de gravure. Ce mode de réalisation peut s'appliquer à chacune des variantes de mise en oeuvre de l'invention.

Les séquences comprenant chacune une étape de modification 440 de la couche de protection 152 et une étape de retrait 450 sont réalisées jusqu'à enlèvement complet du matériau modifié (du nitrure modifié par exemple) de la couche de protection modifiée 158. Le nombre de séquences est calculé en fonction de la vitesse de gravure de la première séquence.

Un autre mode de réalisation de l'invention est illustré en **figures 8a** à **8f****.** La **figure 7** résume les principales étapes 410 à 450 du présent mode de réalisation alternatif.

Dans ce mode de réalisation, on modifie la couche de protection 152 en dehors des flancs avant de déposer le film carboné 217 puis de retirer ce dernier en dehors des flancs. C'est seulement après que l'on effectue le retrait de la couche de protection modifiée 158.

Ce mode de réalisation présente pour avantage de permettre une implantation au plus près de la grille. L'épaisseur modifiée de la couche de protection 152 est donc maîtrisée avec plus de précision. Au final ce mode de réalisation permet de répondre avec une très grande efficacité à la problématique consistant à améliorer la précision de la formation des espaceurs de la grille.

Comme les deux modes de réalisation précédents, le présent mode de réalisation alternatif commence par l'étape de formation 410 d'une couche de protection 152 recouvrant un transistor 200, comme illustré en **figures 8a** et **8b****.**

La **figure 8c** montre la structure du transistor 200 obtenue à l'issue de l'étape de modification 440 de la couche de protection 152. On notera qu'à la différence des autres modes de réalisation, l'étape de modification 440 de la couche de protection 152 est effectuée avant l'étape de formation 420 du film carboné 217.

Cette étape de modification 440 peut être effectuée selon les explications données pour le mode de réalisation illustré précédemment en **figures 4a** à **4c****,****5, 4d** et 4e ou pour celui illustré précédemment en **figures 4a** à **4e****.**

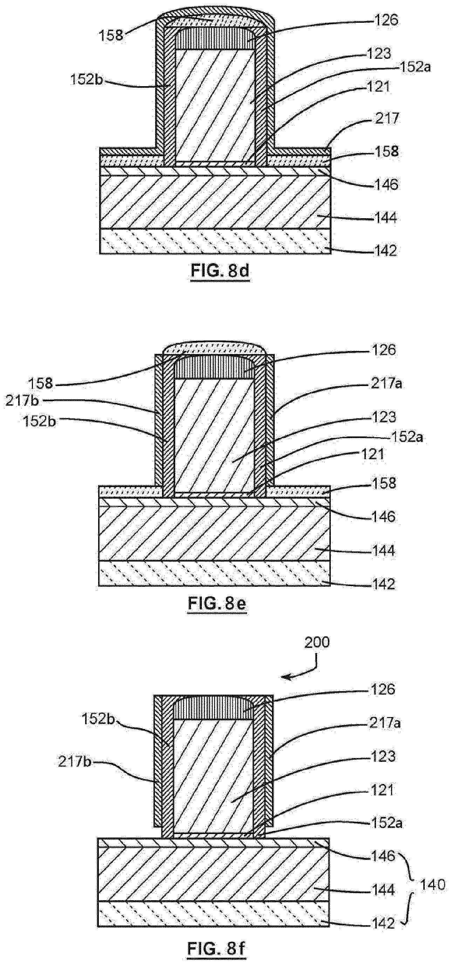

L'étape de formation 420 d'un film carboné 217 et l'étape de retrait 430 du film carboné 217 sont ensuite réalisées, comme illustré en **figures 8d** et **8e****.** Selon le présent mode de réalisation alternatif, le film carboné 217 est disposé directement au contact des surfaces des structures en cours de fabrication ; c'est-à-dire que le film carboné 217 est disposé directement au contact de la couche de protection modifiée 158 et des portions non-modifiées 152a, 152b de la couche de protection 152. Ainsi le film carboné n'est pas au contact direct de la couche active.

Le film carboné 217 est ensuite retiré notamment sur le sommet de la grille et de part et d'autre de la grille de manière à laisser en place tout ou partie du film carboné sur les flancs de la grille comme illustré en figure **8e****.**

Les étapes 420 et 430 peuvent être exécutées comme celles du mode de réalisation décrit en référence aux **figures 4a** à **4c****,** **5, 4d** et **4e** et comme celles du mode de réalisation décrit aux **figures 4a** à **4e****.**

Ensuite, l'étape de retrait 450 est, comme décrite précédemment, effectuée pour enlever, préférentiellement de manière anisotrope, la couche de protection modifiée 158, comme illustré en **figure 8f****.** Cette étape de retrait 450 peut être effectuée de la même manière que celles décrites en références au mode de réalisation illustré précédemment en **figures 4a** à **4c****,** **5, 4d** et **4e** ou à celui au mode de réalisation illustré précédemment en **figures 4a** à **4e****.**

Le résultat de la **figure 8f** peut être le résultat d'une seule étape de retrait 450 ou d'une pluralité de séquence comprenant cette étape 450.

Selon le présent mode de réalisation alternatif, les opérations de retrait 450 de la couche de protection modifiée 158, peuvent optionnellement être répétées 460 jusqu'à enlèvement complet du matériau modifié (du nitrure modifié par exemple) de la couche de protection modifiée 158, afin de pallier le problème qui peut être induit par l'étape de gravure principale 320, comme décrit ci-dessus et illustré en figure 2c. Le nombre de séquences est calculé en fonction de la vitesse de gravure de la première séquence. Le retrait se fait de préférence dans ce cas sous la forme d'un retrait par voie sèche comme décrit dans la **figure 6** puisque, comme on la remarqué plus haut, les deux opérations peuvent se pratiquer dans le même réacteur de gravure.

De la description qui précède, il ressort de nombreux avantages conférés par l'invention. Le procédé de l'invention permet notamment une modification anisotrope réalisée de manière très sélective au carbone et au matériau non-modifié (par exemple le nitrure non-modifié) qui constituent des espaceurs carbonés et des espaceurs de protection pour la grille et à un matériau semi-conducteur tel que le silicium.

Le procédé de l'invention s'avère particulièrement avantageuse pour former les espaceurs de transistors de type MOSFET ou FinFET.

Le procédé de la présente invention permet de contrôler très précisément la dimension des espaceurs tout en s'affranchissant ou en réduisant les problèmes détaillés précédemment, par exemple : la consommation excessive de silicium de la couche active, la formation de pieds au niveau des espaceurs de la grille à l'interface avec le substrat SOI tel que décrit en figures 1b et 1c ainsi que l'érosion des espaceurs de la grille tel que décrit en figure 1d.

L'invention n'est pas limitée aux seuls modes et exemples de réalisation décrits ci-dessus, mais s'étend à tous les modes de réalisation entrant dans la portée des revendications.

## Revendications

1. Procédé de formation d'espaceurs (152a, 152b) d'une grille (120) d'un transistor à effet de champ (200), la grille (120) présentant un sommet et des flancs et étant située au-dessus d'une couche active (146) en un matériau semi-conducteur, le procédé comprenant une étape de formation (410) d'une couche de protection (152) recouvrant la grille (120) dudit transistor (200), la couche de protection (152) présentant une constante diélectrique égale ou inférieure à 8, le procédé étant **caractérisé en ce qu'**il comprend après l'étape de formation (410) de la couche de protection (152) :
- au moins une étape de formation (420) d'un film carboné (217) sur le transistor (200) ;
- après l'étape de formation (420) du film carboné (217), au moins une étape de retrait (430) du film carboné (217) sur le sommet de la grille (120) et de part et d'autre de la grille (120) par mise en présence du film carboné (217) avec un plasma créant un bombardement d'ions plus lourds que les ions hydrogène (H2) selon une direction principale de sorte à enlever au moins des portions du film carboné (217) situées sur le sommet et de part et d'autre de la grille (120) et qui sont perpendiculaires à ladite direction principale, en laissant en place des portions résiduelles (217a, 217b) du film carboné (217) au niveau des flancs de la grille (120) ;
- au moins une étape de modification (440) de la couche de protection (152) par mise en présence de la couche de protection (152) avec un plasma comprenant des ions à base d'hydrogène (H, H⁺, H₂⁺, H₃⁺ etc.) et/ou à base d'hélium (He) et créant un bombardement d'ions ions à base d'hydrogène (H, H⁺, H₂⁺, H₃⁺ etc.) et/ou à base d'hélium (He) anisotrope selon ladite direction principale qui est parallèle à des flancs de la grille (120), ledit bombardement étant effectué de sorte à modifier au moins des portions (158) de la couche de protection (152) qui sont situées sur le sommet et de part et d'autre de la grille (120) et qui sont perpendiculaires aux flancs de la grille (120) en conservant des portions non-modifiées (152a, 152b) de la couche de protection (152) recouvrant les flancs de la grille (120) ; et
- après l'étape de modification (440) de la couche de protection (152), l'étape de formation (420) du film carboné (217) et l'étape de retrait (430) de portions du film carboné (217) laissant en place des portions résiduelles (217a, 217b) du film carboné (217) au niveau des flancs de la grille (120), au moins une étape de retrait (450) de la couche de protection modifiée (152) à l'aide d'une gravure sélective de la couche de protection modifiée (158) vis-à-vis des portions non-modifiées (152a, 152b) de la couche de protection (152) et vis-à-vis des portions résiduelles (217a, 217b) du film carboné (217) ;
et dans lequel l'au moins une étape de formation (420) du film carboné (217) et l'au moins une étape de modification (440) de la couche de protection (152) ne sont pas réalisées simultanément.

2. Procédé selon la revendication précédente dans lequel la couche de protection (152) est une couche à base de nitrure ou une couche dont le matériau présente une constante diélectrique égale ou inférieure à celle du nitrure de silicium.

3. Procédé selon l'une quelconque des revendications précédentes dans lequel, l'étape de formation (420) du film carboné (217) est réalisée à partir d'un plasma à base de CxHyFz, CxHy or CxFy où x est la proportion de carbone, y et/ou z sont respectivement la proportion d'hydrogène ou/et du fluor.

4. Procédé selon la revendication précédente dans lequel le CxHy est le CH4.

5. Procédé selon l'une quelconque des revendications précédentes dans lequel le plasma utilisé lors de l'étape de retrait (430) de portions du film carboné (217) comprend des ions pris parmi l'argon (Ar), l'hélium (He), l'azote (N2) et l'oxygène (O2).

6. Procédé selon l'une quelconque des revendications précédentes dans lequel lors de l'étape de modification (440) les conditions du plasma, en particulier la concentration, l'énergie des ions à base d'hydrogène (H, H⁺, H₂⁺, H₃⁺ etc.) et/ou à base d'hélium (He) et la direction principale d'implantation sont choisies de manière à ce que, au niveau des surfaces perpendiculaires à la direction principale toute l'épaisseur de la couche de protection (152) soit modifiée par l'implantation desdits ions du plasma de l'étape de modification (440) et dans lequel l'étape de retrait (450) est réalisée de manière à retirer toute la couche de protection modifiée (158), mettant ainsi à nu la couche active (146) au niveau des surfaces perpendiculaires à ladite direction principale.

7. Procédé selon l'une quelconque des revendications précédentes dans lequel la couche de protection (152) est prise parmi : une couche à base de nitrure de silicium, une couche de nitrure de silicium, le nitrure de bore (BN), le SiCBN, le SiOCN, le SiCO, le SiC.

8. Procédé selon l'une quelconque des revendications précédentes dans lequel l'étape de retrait (450) de la couche de protection modifiée (158) est effectuée par gravure humide.

9. Procédé selon l'une quelconque des revendications 1 à 7 dans lequel l'étape de retrait (450) est effectuée par gravure sèche sélective de ladite couche modifiée (158) vis-à-vis dudit film carboné (217), vis-à-vis des portions non-modifiées (152a, 152b) de la couche de protection (152) et vis-à-vis dudit matériau semi-conducteur et de préférence dans lequel la gravure sèche comprend :
une étape de gravure (620) consistant en la formation de sels solides ;
une étape de sublimation (630) des espèces solides.

10. Procédé selon l'une quelconque des revendications précédentes dans lequel l'étape de retrait (430) de portions du film carboné (217) et l'étape de modification (440) sont réalisées simultanément.

11. Procédé selon la revendication précédente dans lequel l'étape de retrait (430) de portions du film carboné (217) et l'étape de modification (440) de la couche de protection (152) sont réalisées simultanément et en utilisant un même plasma comprenant des ions H et/ou He.

12. Procédé selon la revendication précédente dans lequel le plasma comprend en outre des ions pris parmi l'argon (Ar), l'hélium (He), l'azote (N2) et/ou l'oxygène (O2).

13. Procédé selon l'une quelconque des revendications 1 à 9 dans lequel l'étape de modification (440) de la couche de protection (152) est effectuée après l'étape de formation (420) du film carboné (217) et après l'étape de retrait de portions du film carboné (217).

14. Procédé selon l'une quelconque des revendications 1 à 9 dans lequel l'étape de modification (440) de la couche de protection (152) est effectuée préalablement à l'étape de formation (420) du film carboné (217).

15. Procédé selon la revendication précédente dans lequel l'étape de modification (440) est précédée d'une étape de gravure (320) anisotrope qui est effectuée dans un plasma de type CH3F/O2/He.

## Patentansprüche

1. Verfahren zum Bilden von Abstandshaltern (152a, 152b) eines Gates (120) eines Feldeffekttransistors (200), wobei das Gate (120) eine Spitze und Flanken aufweist und sich über einer aktiven Schicht (146) aus einem Halbleitermaterial befindet, wobei das Verfahren einen Schritt des Bildens (410) einer Schutzschicht (152) umfasst, die das Gate (120) des Transistors (200) bedeckt, wobei die Schutzschicht (152) eine Dielektrizitätskonstante von gleich oder kleiner als 8 aufweist, wobei das Verfahren **dadurch gekennzeichnet ist, dass** es nach dem Schritt des Bildens (410) der Schutzschicht (152) umfasst:
- mindestens einen Schritt des Bildens (420) eines kohlenstoffhaltigen Films (217) auf dem Transistor (200);
- nach dem Schritt des Bildens (420) des kohlenstoffhaltigen Films (217) mindestens einen Schritt des Entfernens (430) des kohlenstoffhaltigen Films (217) an der Spitze des Gates (120) und auf beiden Seiten des Gates (120) durch Zusammenbringen des kohlenstoffhaltigen Films (217) mit einem Plasma, das einen Beschuss schwererer Ionen als der Wasserstoff- (H2) Ionen in einer Hauptrichtung erzeugt, um mindestens Abschnitte des kohlenstoffhaltigen Films (217), die sich an der Spitze und auf beiden Seiten des Gates (120) befinden und die zur Hauptrichtung senkrecht sind, unter Belassen von Restabschnitten (217a, 217b) des kohlenstoffhaltigen Films (217) im Bereich der Flanken des Gates (120) abzutragen;
- mindestens einen Schritt des Modifizierens (440) der Schutzschicht (152) durch Zusammenbringen der Schutzschicht (152) mit einem Plasma, das Ionen auf Basis von Wasserstoff (H, H⁺, H₂⁺, H₃⁺, usw.) und/oder auf Basis von Helium (He) umfasst und einen anisotropen Beschuss von Ionen auf Basis von Wasserstoff (H, H⁺, H₂⁺, H₃⁺, usw.) und/oder auf Basis von Helium (He) in der Hauptrichtung erzeugt, der zu Flanken des Gates (120) parallel ist, wobei der Beschuss so erfolgt, dass mindestens Abschnitte (158) der Schutzschicht (152), die sich an der Spitze und auf beiden Seiten des Gates (120) befinden und die zu den Flanken des Gates (120) senkrecht sind, unter Beibehaltung von nicht modifizierten Abschnitten (152a, 152b) der Schutzschicht (152), die die Flanken des Gates (120) bedecken, modifiziert werden; und
- nach dem Schritt des Modifizierens (440) der Schutzschicht (152), dem Schritt des Bildens (420) des kohlenstoffhaltigen Films (217) und dem Schritt des Entfernens (430) von Abschnitten des kohlenstoffhaltigen Films (217), der Restabschnitte (217a, 217b) des kohlenstoffhaltigen Films (217) im Bereich der Flanken des Gates (120) belässt, mindestens einen Schritt des Entfernens (450) der modifizierten Schutzschicht (152) mit Hilfe eines selektiven Ätzens der modifizierten Schutzschicht (158) gegenüber den nicht modifizierten Abschnitten (152a, 152b) der Schutzschicht (152) und gegenüber den Restabschnitten (217a, 217b) des kohlenstoffhaltigen Films (217);
und wobei der mindestens eine Schritt des Bildens (420) des kohlenstoffhaltigen Films (217) und der mindestens eine Schritt des Modifizierens (440) der Schutzschicht (152) nicht gleichzeitig ausgeführt werden.

2. Verfahren nach dem vorstehenden Anspruch, wobei die Schutzschicht (152) eine Schicht auf Basis von Nitrid oder eine Schicht ist, deren Material eine Dielektrizitätskonstante von gleich oder kleiner als jener des Siliziumnitrids aufweist.

3. Verfahren nach einem der vorstehenden Ansprüche, wobei der Schritt des Bildens (420) des kohlenstoffhaltigen Films (217) auf Grundlage eines Plasmas auf Basis von CxHyFz, CxHy oder CxFy ausgeführt wird, wobei x der Kohlenstoffanteil ist, y und/oder z jeweils der Anteil an Wasserstoff und/oder Fluor sind.

4. Verfahren nach dem vorstehenden Anspruch, wobei CxHy CH4 ist.

5. Verfahren nach einem der vorstehenden Ansprüche, wobei das beim Schritt des Entfernens (430) von Abschnitten des kohlenstoffhaltigen Films (217) verwendete Plasma Ionen, ausgewählt aus Argon (Ar), Helium (He), Stickstoff (N2) und Sauerstoff (O2), umfasst.

6. Verfahren nach einem der vorstehenden Ansprüche, wobei beim Schritt des Modifizierens (440) die Bedingungen des Plasmas, insbesondere die Konzentration, die Energie der Ionen auf Basis von Wasserstoff (H, H⁺, H₂⁺, H₃⁺, usw.) und/oder auf Basis von Helium (He), und die Hauptimplantationsrichtung so gewählt werden, dass im Bereich der Flächen, die zur Hauptrichtung senkrecht sind, die gesamte Dicke der Schutzschicht (152) durch die Implantation der Ionen des Plasmas aus dem Modifikationsschritt (440) modifiziert wird, und wobei der Schritt des Entfernens (450) so ausgeführt wird, dass die gesamte modifizierte Schutzschicht (158) entfernt wird, wodurch so die aktive Schicht (146) im Bereich der zur Hauptrichtung senkrechten Flächen bloßgelegt wird.

7. Verfahren nach einem der vorstehenden Ansprüche, wobei die Schutzschicht (152) ausgewählt ist aus: einer Schicht auf Basis von Siliziumnitrid, einer Schicht aus Siliziumnitrid, Bornitrid (NB), SiCBN, SiOCN, SiCO, SiC.

8. Verfahren nach einem der vorstehenden Ansprüche, wobei der Schritt des Entfernens (450) der modifizierten Schutzschicht (158) durch Nassätzen erfolgt.

9. Verfahren nach einem der Ansprüche 1 bis 7, wobei der Schritt des Entfernens (450) durch selektives Trockenätzen der modifizierten Schicht (158) gegenüber dem kohlenstoffhaltigen Film (217), gegenüber den nicht modifizierten Abschnitten (152a, 152b) der Schutzschicht (152) und gegenüber dem Halbleitermaterial erfolgt, und wobei das Trockenätzen vorzugsweise umfasst:
einen Ätzschritt (620), der in der Bildung von festen Salzen besteht;
einen Sublimationsschritt (630) der festen Spezies.

10. Verfahren nach einem der vorstehenden Ansprüche, wobei der Schritt des Entfernens (430) von Abschnitten des kohlenstoffhaltigen Films (217) und der Schritt des Modifizierens (440) gleichzeitig ausgeführt werden.

11. Verfahren nach dem vorstehenden Anspruch, wobei der Schritt des Entfernens (430) von Abschnitten des kohlenstoffhaltigen Films (217) und der Schritt des Modifizierens (440) der Schutzschicht (152) gleichzeitig und unter Verwendung ein und desselben Plasmas ausgeführt werden, das H- und/oder He-Ionen umfasst.

12. Verfahren nach dem vorstehenden Anspruch, wobei das Plasma weiter Ionen, ausgewählt aus Argon (Ar), Helium (He), Stickstoff (N2) und/oder Sauerstoff (O2), umfasst.

13. Verfahren nach einem der Ansprüche 1 bis 9, wobei der Schritt des Modifizierens (440) der Schutzschicht (152) nach dem Schritt des Bildens (420) des kohlenstoffhaltigen Films (217) und nach dem Schritt des Entfernens von Abschnitten des kohlenstoffhaltigen Films (217) erfolgt.

14. Verfahren nach einem der Ansprüche 1 bis 9, wobei der Schritt des Modifizierens (440) der Schutzschicht (152) vor dem Schritt des Bildens (420) des kohlenstoffhaltigen Films (217) erfolgt.

15. Verfahren nach dem vorstehenden Anspruch, wobei dem Schritt des Modifizierens (440) ein Schritt des anisotropen Ätzens (320) vorausgeht, der in einem Plasma vom Typ CH3F/O2/He erfolgt.

## Claims

1. Method for forming spacers (152a, 152b) of a gate (120) of a field-effect transistor (200), the gate (120) having a top and sides and being situated above an active layer (146) made of a semi-conductive material, the method comprising a step of forming (410) a protective layer (152) covering the gate (120) of said transistor (200), the protective layer (152) having a dielectric constant equal to or less than 8, the method being **characterised in that** it comprises, after the step of forming (410) the protective layer (152);
- at least one step of forming (420) a carbon film (217) on the transistor (200);
- after the step of forming (420) the carbon film (217), at least one step of removing (430) the carbon film (217) on the top of the gate (120) and on either side of the gate (120) by putting the carbon film (217) in contact with a plasma creating a bombardment of ions heavier than hydrogen (H₂) ions along a main direction so as to remove at least portions of the carbon film (217) situated on the top and either side of the gate (120) and which are perpendicular to said main direction, by leaving in place residual portions (217a, 217b) of the carbon film (217) at the level of the edges of the gate (120);
- at least one step of modifying (440) the protective layer (152) by putting the protective layer (152) in contact with a plasma comprising hydrogen-based (H, H⁺, H₂⁺, H₃⁺, etc.) and/or helium-based (He) ions and creating an anisotropic bombardment of hydrogen-based (H, H⁺, H₂⁺, H₃⁺, etc.) and/or helium-based (He) ions along said main direction which is parallel to edges of the gate (120), said bombardment being achieved so as to modify at least portions (158) of the protective layer (152) which are situated on the top and either side of the gate (120) and which are perpendicular to the edges of the gate (120) by preserving non-modified portions (152a, 152b) of the protective layer (152) covering the edges of the gate (120); and
- after the step of modifying (440) the protective layer (152), the step of forming (420) the carbon film (217) and the step of removing (430) portions of the carbon film (217) leaving in place residual portions (217a, 217b) of the carbon film (217) at the level of the edges of the gate (120), at least one step of removing (450) the modified protective layer (152) using an etching of the modified protective layer (158) which is selective relative to non-modified portions (152a, 152b) of the protective layer (152) and to opposite residual portions (217a, 217b) of the carbon film (217);
and wherein the at least one step of forming (420) the carbon film (217) and the at least one step of modifying (440) the protective layer (152) are not simultaneously produced.

2. Method according to the preceding claim, wherein the protective layer (152) is a nitride-based layer or a layer of which the material has a dielectric constant equal to or less than that of silicon nitride.

3. Method according to any one of the preceding claims, wherein the step of forming (420) the carbon film (217) is carried out from a CxHyFz, CxHy or CxFy-based plasma, where x is the carbon proportion, y and/or z are respectively the hydrogen and/or fluorine proportion.

4. Method according to the preceding claim, wherein CxHy is CH₄.

5. Method according to any one of the preceding claims, wherein the plasma used during the step of removing (430) portions of the carbon film (217) comprises ions taken from among argon (Ar), helium (He), nitrogen (N₂) and oxygen (O₂).

6. Method according to any one of the preceding claims, wherein during the step of modifying (440) the conditions of the plasma, in particular the concentration, the energy from the hydrogen-based (H, H⁺, H₂⁺, H₃⁺, etc.) and/or helium-based (He) ions and the main implantation direction are selected such that, at the level of the surfaces perpendicular to the main direction, the whole thickness of the protective layer (152) is modified by the implantation of said ions of the plasma of the modification step (440) and wherein the removal step (450) is carried out so as to remove the whole modified protective layer (158), thus stripping the active layer (146) at the level of the surfaces perpendicular to said main direction.

7. Method according to any one of the preceding claims, wherein the protective layer (152) is taken from among: a silicon nitride-based layer, a silicon nitride-based layer, boron nitride (BN), SiCBN, SiOCN, SiCO, SiC.

8. Method according to any one of the preceding claims, wherein the step of removing (450) the modified protective layer (158) is carried out by wet etching.

9. Method according to any one of claims 1 to 7, wherein the removal step (450) is carried out by selective dry etching of said modified layer (158) opposite said carbon film (217), opposite non-modified portions (152a, 152b) of the protective layer (152) and opposite said semi-conductive material and preferably wherein the dry etching comprises:
an etching step (620) consisting of forming solid salts;
a step of sublimating (630) solid species.

10. Method according to any one of the preceding claims, wherein the step of removing (430) portions of the carbon film (217) and the modification step (440) are carried out simultaneously.

11. Method according to the preceding claim, wherein the step of removing (430) portions of the carbon film (217) and the step of modifying (440) the protective layer (152) are carried out simultaneously and by using one same plasma comprising H and/or He ions.

12. Method according to the preceding claim, wherein the plasma further comprises ions taken from among argon (Ar), helium (He), nitrogen (N₂) and/or oxygen (O₂).

13. Method according to any one of claims 1 to 9, wherein the step of modifying (440) the protective layer (152) is carried out after the step of forming (420) the carbon film (217) and after the step of removing portions of the carbon film (217).

14. Method according to any one of claims 1 to 9, wherein the step of modifying (440) the protective layer (152) is carried out prior to the step of forming (420) the carbon film (217).

15. Method according to the preceding claim, wherein the modification step (440) is preceded by an anisotropic etching step (320) which is carried out in a CH₃F/O₂/He-type plasma.
